Europäisches Patentamt

European Patent Office

Office européen des brevets

(11) Numéro de publication: **0 204 612**
**B1**

(12) **FASCICULE DE BREVET EUROPEEN**

(45) Date de publication du fascicule du brevet: **01.08.90**

(51) Int. Cl.⁵: **H 03 M 13/00, G 06 F 11/10**

(21) Numéro de dépôt: **86401109.3**

(22) Date de dépôt: **27.05.86**

(54) Procédé de transmission, avec possibilité de correction de paquets d'erreurs, de messages d'information et dispositifs de codage et de décodage pour la mise en oeuvre de ce procédé.

(30) Priorité: **30.05.85 FR 8508098**

(43) Date de publication de la demande:
**10.12.86 Bulletin 86/50**

(45) Mention de la délivrance du brevet:
**01.08.90 Bulletin 90/31**

(84) Etats contractants désignés:
**AT BE CH DE GB IT LI NL SE**

(56) Documents cités:
**WO-A-81/00316**
**WO-A-85/01625**

**ARCHIV FÜR ELEKTRONIK UND ÜBERTRAGUNGSTECHNIK, vol. 38, no. 5, septembre/octobre 1984, pages 281-289, Würzburg, DE; M. PRÖGLER et al.: "Realisierung algebraischer Fehlerkorrektur mit Standard-Mikrorechnern"**

**IEEE TRANSACTIONS ON INFORMATIONS THEORY, vol. IT-19, no. 5, septembre 1973, pages 590-592, New York, US; E.R. BERLEKAMP: "Goppa codes"**

(73) Titulaire: **LABORATOIRE CENTRAL DE TELECOMMUNICATIONS Société anonyme; 18-20, rue Grange-Dame-Rose F-78140 Velizy Villacoublay (FR)**

(72) Inventeur: **Dornstetter, Jean-Louis 13, rue du Général Pershing F-78000 Versailles (FR)**

(74) Mandataire: **Ballot, Paul Denis Jacques Cabinet Ballot 7, rue le Sueur F-75116 Paris (FR)**

(56) References cited:
**IEEE TRANSACTIONS ON COMPUTERS, vol. C-33, no. 2, février 1984, pages 178-189, IEEE, New York, US; KUANG YUNG LIU: "Architecture for VLSI design of reed-solomon decoders"**

**THE TRANSACTIONS OF THE IECE OF JAPAN, vol. E-64, no. 10, octobre 1981, pages 653-660, Tokyo, JP; E. FUJIWARA et al.: "Fault-tolerant arithmetic logic unit using parity-based codes"**

EP 0 204 612 B1

Courier Press, Leamington Spa, England.

**Description**

La présente invention se rapporte à un procédé de transmission, avec possibilité de correction de paquets d'erreurs, de messages d'information à $k$ éléments binaires à l'aide de mots de code à $n$ éléments binaires constitués de $s$ blocs de taille $d_i$ où $i$ varie de 1 à $s$, $s$ étant le nombre de polynômes $P_i(X)$ d'une décomposition en facteurs de $X^n+1$ sur le corps GF(2) à deux éléments et $d_i$ étant le degré du polynôme $P_i(X)$.

L'invention se rapporte également à un dispositif de codage et à un dispositif de décodage pour la mise en oeuvre de ce procédé.

Dans la transmission d'information ou de données, on a de plus en plus souvent besoin de procédés permettant au moins de détecteur des erreurs de transmission et, dans la plupart des cas, on cherche de plus à corriger ces erreurs.

En ce qui concerne la correction d'une ou plusieurs erreurs dans la transmission, il existe de très nombreux procédés de correction et on trouve dans la littérature la description de nombreux types de codes. Cependant, on cherche de plus en plus à détecter et corriger également des paquets d'erreurs pour améliorer la sécurité des transmissions d'information. Parmi les familles de codes permettant d'obtenir des performances satisfaisantes, l'une des plus efficaces est celle des codes de Bose-Chaudhuri-Hocquenghem (BCH) et, en particulier, parmi ceux-ci, les codes de Reed-Solomon sont parmi les plus puissants et font l'objet de nombreuses recherches et applications. Les mots de code obtenus peuvent être considérés comme des combinaisons d'éléments d'un corps de Galois GF($2^m$) et il est nécessaire pour les traiter d'utiliser des circuits spécialisés qui sont des arrangements complexes de portes logiques. Ces circuits ont en général un schéma irrégulier et nécessitent un grand nombre de connexions spéciales. En conséquence, ils sont difficilement réalisables sous forme intégrée. Par ailleurs, si on envisage d'effectuer les opérations de multiplication de polynômes indispensables à l'aide de mémoires mortes, ces opérations deviennent vite très compliquées et irréalisables sous forme intégrée dès qu'on dépasse un ordre très faible.

La correction de paquets d'erreurs exige même pour les codes BCH un nombre de bits de redondance assez important.

Certaines tentatives ont été faites pour modifier des procédures de décodage connues de façon à obtenir une technique de décodage répétitive et récursive qui puisse être réalisable sous forme de circuits VLSI. Une telle solution pour les codes de Reed-Solomon a été décrite, en particulier, dans un article de Kuang Yung Liu intitulé "Architecture for VLSI design of Reed-Solomon decoders" paru dans la revue IEEE Transactions on Computers, vol. C—33, n° 2, Février 1984, pages 178 à 189. Cet article décrit d'abord les procédures de décodage modifiées utilisées qui conduisent à définir cinq étapes dans le décodage. Un décodage convenable dans ces cinq étapes permet alors de définir un traitement du type pipe-line qui se sub-divisant en trois étages de circuits. Un tel traitement exige pour se dérouler une durée équivalente en nombre de cycles d'horloge à la réception de trois mots de code. Il est donc nécessaire de prévoir une mémoire tampon pouvant stocker les trois mots de code actifs à chaque instant. Une architecture VLSI est décrite pour chacun des trois étages du traitement. On obtient bien une structure répétitive, donc intégrable.

Cependant, cette solution est encore relativement complexe et coûteuse en circuits. De plus, le temps de traitement d'un mot de code est relativement long.

Un objet de la présente invention est donc un procédé de transmission amélioré qui remédie à ces inconvénients grâce à la définition d'une famille de codes particulière plus efficace qui n'est, notamment, pas plus coûteuse en bits de redondance que les codes de Reed-Solomon.

Un autre objet de l'invention est un procédé de transmission conduisant à des dispositifs de codage et de décodage ayant des structures tout à fait répétitives et donc aisément intégrables et utilisant de manière optimale chaque temps d'horloge pour réduire le temps de traitement.

Avant de donner une définition plus précise de l'invention, on va indiquer certaines conventions d'écriture qui seront utilisées dans l'énoncé des caractéristiques de l'invention et dans toute la description qui va suivre. On écrira: $A(X) \equiv B(X)$ [C(X)] pour exprimer que les polynômes $A(X)$ et $B(X)$ sont congrus modulo $C(X)$, c'est-à-dire que: $A(X) = C(X) Q(X) + B(X)$

De même, on écrira $\overline{M(X)}$ le polynôme réciproque du polynôme $M(X)$, c'est-à-dire: $\overline{M(X)} = X^{k-1} M(X^{-1})$ où k-1 est le degré maximum du polynôme $M(X)$, c'est-à-dire son degré lorsque le coefficient de plus fort poids de $M(X)$ n'est pas nul.

On appellera dérivé du polynôme

$$P_i(X) = \sum_{j=0}^{d_i} p_j^i X^j \text{ le polynôme } P_i'(X) \; : \; P_i'(X) = \sum_{\substack{j=1 \\ j \text{ impair}}}^{d_i} p_j^i X^{j-1}$$

Enfin les signes + et $\Sigma$ utilisés se rapportent à l'addition binaire ou addition modulo 2. On utilisera en particulier le signe $\oplus$ pour cette addition lorsque cela correspondra à un circuit matériel effectuant cette opération et qui remplit la fonction OU exclusif.

Selon une caractéristique de l'invention, il est donc prévu un procédé de transmission, avec possibilité de correction de paquets d'erreurs, de messages d'information à $k$ éléments binaires à l'aide de mots de code à $n$ éléments binaires constitués de $s$ blocs de taille $d_i$ où $i$ varie de 1 à $s$, $s$ étant le nombre de polynômes $P_i(X)$ d'une décomposition en facteurs de $X^n+1$ sur le corps GF(2) à deux éléments et $d_i$ étant le degré du polynôme $P_i(X)$, ledit procédé étant caractérisé en ce que, à l'émission:

— on calcule, pour chaque bloc constitué par les coefficients d'un polynôme $m_i(X)$, le produit du polynôme $\overline{M(X)}$, réciproque du polynôme $M(X)$ de degré k-1 associé au message à transmettre, par le polynôme $A_i(X)$, réciproque du polynôme $P'_i(X)$ qui est le dérivé du polynôme $P_i(X)$;

— on effectue la division dudit produit par le polynôme $\overline{P_i(X)}$ et on prend comme coefficients du polynôme $m_i(X)$ les coefficients du reste de cette division, selon la relation $m_i(X) \equiv \overline{M(X)} A_i(X) [\overline{P_i(X)}]$, ces coefficients constituant les éléments binaires du bloc correspondant transmis;

et en ce qu'à la réception:

— on calcule pour chaque bloc reçu un polynôme $S_i(X)$ à $n$ coefficients qui est le produit du polynôme $\overline{m'_i(X)}$, réciproque du polynôme $m'_i(X)$ associé au bloc reçu, par un polynôme de reconstitution

$$R_i(X) = \frac{X^n+1}{P_i(X)},$$

la somme desdits polynômes $S_i(X)$ représentant la superposition du message transmis $M(X)$ et d'un syndrome d'erreur;

— on détermine, à l'aide des n-k premiers coefficients de la somme des polynômes $S_i(X)$, les coefficients d'un polynôme $\sigma(X)$ produit des polynômes $P_i(X)$ correspondant aux blocs $i$ en erreur;

— on calcule les $k$ coefficients de poids le plus élevé d'un polynôme

$$K(X) = \sum_{i=0}^{n-1} k_i X^i \text{ de correction tel que :}$$

$$K(X) \equiv \sum_{j=1}^{s} S_j(X) \quad [X^{n-k}] \sum_{m=0}^{t_x} \sigma_m \cdot k_{p-m} = 0 \quad \text{pour } p \geqslant n-k$$

$\sigma_m$ représentant les coefficients du polynôme $\sigma(X)$ de degré maximum $t_x$ autorisé pour une correction valable; et

— on fait la somme de chacun desdits $k$ coefficients de poids le plus élevé du polynôme $K(X)$ avec les coefficients de même poids de la somme des polynômes $S_i(X)$ pour obtenir les $k$ éléments binaires corrigés du message reçu.

Avec un tel procédé et grâce à des caractéristiques adéquates dans la conception des circuits de codage et de décodage, on parvient à des structures identiques pour le codage et le calcul des polynômes $S_i(X)$ et à une structure tout à fait répétitive et simple pour les circuits de détection et correction d'erreurs. Ceci a le grand avantage de permettre une réalisation sous forme intégrée très facile.

Par ailleurs, on obtient des circuits de décodage qui admettent un fonctionnement en pipe-line et sont donc utilisés de manière optimale.

L'invention sera mieux comprise et d'autres caractéristiques et avantages apparaîtront à l'aide de la description ci-après et des dessins joints où:

— la figure 1 représente un schéma de principe des circuits de codage et des circuits de calcul de la somme du message et du syndrome à la réception, dans un mode de réalisation selon l'invention;

— la figure 2 est un schéma des circuits de détection et de correction d'erreurs, selon l'invention;

— les figures 3 et 4 représentent des schémas de cellules utilisées dans les circuits de la figure 2;

— la figure 5 est un schéma de cellule modifiée pour permettre le traitement des effacements;

— la figure 6 est un schéma de circuits de détection et de correction d'erreurs selon la figure 2, adaptés pour effectuer également le traitement des effacements;

— la figure 7 représente le schéma de circuits de détection et de correction d'erreurs selon l'invention, fonctionnant selon un algorithme modifié; et

— la figure 8 est le schéma d'une cellule utilisée dans les circuits de la figure 7.

Le choix de la sous-famille de codes qui a été effectué dans le procédé de transmission selon l'invention est basé sur la décomposition en $s$ facteurs $P_i(X)$ du polynôme $X^n+1$, où $n$ est impair, dans le corps de Galois GF(2) à deux éléments et sur les propriétés suivantes de cette décomposition.

Si l'on désigne par $P'_i(X)$ le polynôme dérivé du polynôme $P_i(X($, avec $i$ variant de 1 à $s$, on peut démontrer que:

$$\sum \frac{XP'_i(X)}{P_i(X)} = \frac{X^n}{X^n+1}$$

dont le développement en série est égal à $X^n + X^{2n} + \ldots$

Si l'on considère donc une série de $s$ filtres de fonction de transfert

$$\frac{N_i}{D_i} = \frac{XP'_i(X)}{P_i(X)}$$

à qui on applique successivement les coefficients d'un polynôme d'information et si l'on effectue la sommation des sorties de ces $s$ filtres, on retrouve normalement les $n$ bits appliqués à l'entrée avec un retard de $n$ coups d'horloge et une périodicité $n$.

A partir de ces propriétés, on a donc conçu un procédé de transmission dans lequel le codage consiste à associer à un polynôme d'information $M(X)$ les restes $m_i(X)$ des divisions par $P_i(X)$ de $XP'_i(X)\,M(X)$.

En fait, pour des raisons que nous verrons ci-après liées aux structures des circuits à mettre en oeuvre, on utilise ce principe de codage légèrement modifié.

Plus précisément, soit un message d'information à $k$ bits dont le polynôme associé s'écrit:

$$M(X) = m_0 + m_1X + m_2X^2 + \ldots + m_{k-1}X^{k-1}$$

Considérons la décomposition de $X^n+1$ en polynômes $P_i(X)$ de degré $d_i$ dans le corps GF(2) à deux éléments:

$$P_i(X) = P_0^i + P_1^i X + \ldots + p_{d_i}^i X^d_i$$

Pour coder selon l'invention le message $M(X)$, on va le mettre sous forme d'un mot de code à $n$ éléments binaires constitué de $s$ blocs $m_i(X)$ de taille $d_i$, avec $i$ variant de 1 à $s$, $s$ étant le nombre de polynômes de décomposition $P_i(X)$. On obtient les polynômes $m_i(X)$ selon la relation:

$$m_i(X) \equiv \overline{M(X)}\,A_i(X) \quad [\overline{P_i(X)}] \tag{1}$$

Dans la relation (1), le polynôme $A_i(X)$ est le réciproque du polynôme $P'_i(X)$, dérivé du polynôme $P_i(X)$:

$$A_i(X) = X^{d_i-1}P'_i(X^{-1})$$

Les coefficients des $s$ blocs $m_i(X)$ sont donc transmis et, à la réception, subissent d'abord une opération de décodage qui consiste à calculer un polynôme qui est la somme du message d'information émis $X^{n-k}\,M(X)$ et d'un syndrome d'erreur. Ce dernier est nul lorsqu'il n'y a pas eu d'erreur dans la transmission et les n-k premiers coefficients du polynôme obtenu sont nuls, les $k$ derniers représentant le message reconstitué. S'il y a eu des erreurs dans la transmission par contre, le syndrome n'est pas nul et on évalue, à partir des n-k premiers coefficients, les $k$ coefficients de correction à ajouter aux $k$ coefficients de plus fort poids du polynôme obtenu, pour retrouver les bits du message.

Plus précisément, on calcule pour chaque bloc reçu $m'_i(X)$ [$m'_i(X) = m_i(X)$ s'il n'y a pas eu d'erreur] le polynôme $S_i(X)$ tel que:

$$S_i(X) = \overline{m'_i(X)}R_i(X)$$

degré n-1 avec, selon la convention d'écriture adoptée:

$$\overline{m'_i} = X^{d_i-1}m'_i(X^{-1})$$

et on en fait la somme pour obtenir le polynôme:

$$S(X) = \sum_{i=1}^{s} S_i(X) = \sum_{i=1}^{s} \overline{m'_i(X)}\,R_i(X) \tag{2}$$

où $R_i(X)$ est un polynôme de reconstitution égal à

$$\frac{X^n+1}{P_i(X)}$$

On peut considérer que pour chaque bloc émis $M_i(X)$, on reçoit:

$$m_i'(X) = m_i(X) + E_i(X)$$

où $E_i(X)$ est le polynôme d'erreur correspondant, nul lorsqu'il n'y a pas d'erreur dans la transmission.

On peut démontrer que l'on a la relation:

$$S(X) = \sum_{i=1}^{s} S_i(X) = X^{n-k} M(X) + \left[ \sum_{\substack{i \text{ en} \\ \text{erreur}}} \frac{F_i(X)}{P_i(X)} \right] (X^n + 1) \qquad (3)$$

où la seconde somme $\Sigma$ est relative seulement aux blocs d'indice $i$ contenant des erreurs et où le polynôme $F_i(X)$ est relié au polynôme d'erreur $E_i(X)$ par:

$$F_i(X) = X^{d_i-1} E_i(X^{-1})$$

Dans la relation (3), le premier terme représente l'information utile et le second est caractéristique des erreurs introduites lors de la transmission. Le dénominateur du second terme

$$\sigma_v(X) = \prod_{\substack{i \text{ en} \\ \text{erreur}}} P_i(X)$$

un degré vrai $t_v$ qui est compris entre 0 et $n$ selon les blocs en erreur. Les $n-k=u$ premiers coefficients du terme utile sont nuls et ceci a conduit à penser à utiliser l'algorithme de décodage algébrique de Berlekamp pour trouver le second terme à partir des $u$ premiers coefficients de la relation (3). Un tel décodage conduit à l'obtention d'un polynôme décodé $\sigma_d(X)$ de degré $t_d$. On démontre que, à condition que

$$u \geqslant 2t_v = 2 \sum_{\substack{i \text{ en} \\ \text{erreur}}} d_i$$

on a effectivement $\sigma_d(X) = \sigma_v(X) = \sigma(X)$ et $t_v = t_d = t$ et on peut donc identifier correctement le dénominateur. Dans toute la suite, on supposera que cette condition est remplie.

Il est alors possible de reconstituer les coefficients des puissances $u$ à n-1 du second terme de la relation (3) pour les ajouter modulo 2 aux coefficients correspondants de S(X) de façon à restituer les bits utiles $m_0$ à $m_{k-1}$ corrigés.

Cette reconstitution s'effectue de la manière ci-après:

En posant:

$$K(X) = (X^n + 1) \sum_{\substack{i \text{ en} \\ \text{erreur}}} \frac{F_i(X)}{P_i(X)} = \sum_{i=0}^{n-1} k_i X_i$$

où K(X) sera appelé polynôme de correction, et:

$$H(X) = \sum_{\substack{i \text{ en} \\ \text{erreur}}} F_i(X) \left[ \prod_{\substack{j \neq i \\ j \text{ en} \\ \text{erreur}}} P_j(X) \right]$$

avec degré H(X) $\leqslant t_x - 1$, $t_x$ étant le degré maximum autorisé du polynôme $\sigma(X)$, on a les relations:

$$\sigma(X) K(X) = H(X) (X^n + 1)$$

$$\sigma(X) S(X) \equiv H(X) \quad [X^u]$$

On en conclut donc que les coefficients du produit $\sigma(X) S(X)$ sont nuls pour les termes de degré u, u+1, ..., n-1, ce qui permet de déterminer entièrement le polynôme K(X) dont les $u$ premiers coefficients sont définis par:

$$K(X) \equiv S(X) \quad [X^u]$$

et dont les $k$ coefficients de plus fort poids sont donnés par les relations:

$$\sum_{m=0}^{t} \sigma_m \cdot k_{p-m} = 0 \qquad n-1 \geqslant p \geqslant u \qquad\qquad (4)$$
$$2t \leqslant u$$

où t est le degré effectif du polynôme $\sigma(X)$ et où $\sigma_m$ est le coefficient de rang $m$ du polynôme $\sigma(X)$.

On peut noter que, si l'hypothèse ci-dessus $2t \leqslant u$ est vérifiée, on doit avoir pour p = n, n+1, ..., n+u-1

$$k_p = s_{p-n}$$

où $k_p$ est le coefficient calculé selon la relation (4) et $s_{p-n}$ représente les coefficients du polynôme S(X). Ceci constitue un moyen possible pour contrôler le bon fonctionnement du décodage.

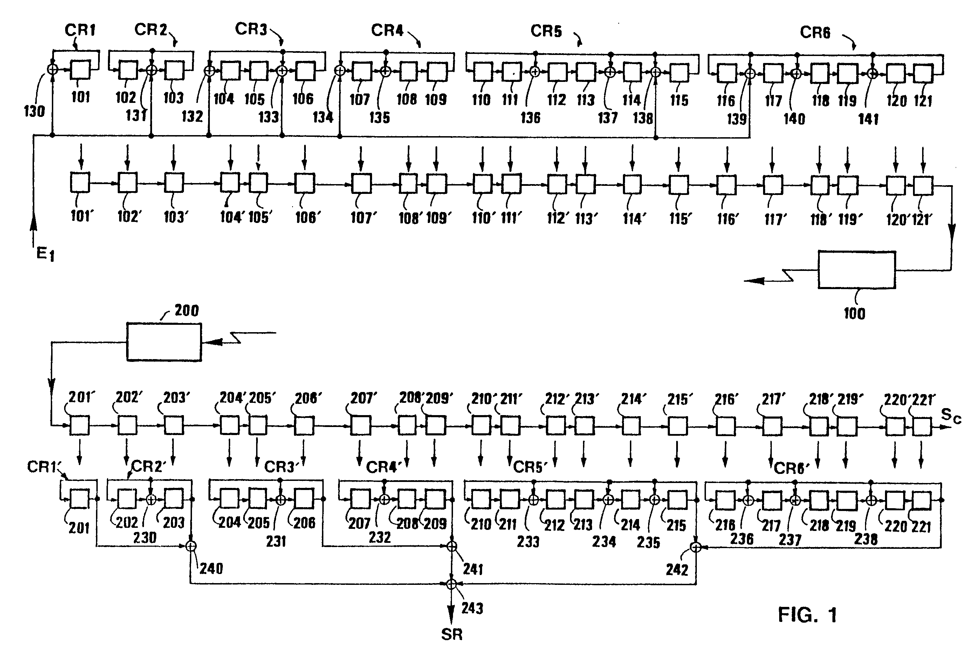

Les principes du procédé de transmission selon l'invention ayant été ainsi exposés, la figure 1 représente un mode de réalisation possible d'un dispositif de codage et de la partie d'un dispositif de décodage effectuant le calcul du polynôme S(X), ces dispositifs mettant en oeuvre le procédé ci-dessus.

A titre d'exemple, pour permettre une représentation de circuits n'ayant pas de dimensions trop importantes, on a choisi pour $n$, qui doit être impair, la valeur 21 bien que cette valeur ne soit pas une valeur optimale et que des valeurs telles que 51 ou 63 par exemple soient préférables en raison de l'homogénéité de la décomposition en facteurs utilisable.

Pour n = 21 et si l'on effectue une décomposition en facteurs irréductibles, on obtient:

$$P_1(X) = 1 + X$$
$$P_2(X) = 1 + X + X^2$$
$$P_3(X) = 1 + X + X^3$$
$$P_4(X) = 1 + X^2 + X^3$$
$$P_5(X) = 1 + X + X^2 + X^4 + X^6$$
$$P_6(X) = 1 + X^2 + X^4 + X^5 + X^6$$

Le dispositif de codage (figure 1) comprend des circuits de calcul CRI à CR6 qui sont formés par des registres à contre-réaction linéaire dont le principe est bien connu et décrit par exemple dans l'ouvrage "Error-correcting codes" par W. W. Peterson et E. J. Weldon, Jr, deuxième édition, 1972, MIT Press, chapitre 7. Ces registres comportent des étages 101, 102—103, ..., 116 à 121 qui sont reliés en série, à l'intérieur de chaque bloc, soit directement, soit par l'intermédiaire d'additionneurs modulo 2, 130 à 141 qui sont des portes OU exclusif.

Dans chaque bloc, la sortie du dernier étage est rebouclée sur l'entrée de différents étages par l'intermédiaire des portes OU exclusif selon une combinaison linéaire qui permet d'effectuer la division du polynôme, dont les coefficients sont appliqués dans l'ordre décroissant à l'entrée du registre, par le polynôme dont les coefficients de valeur $1$ sont associés aux liaisons effectives de contre-réaction.

Ainsi, dans le circuit de calcul CR6, les liaisons de contre-réaction aux entrées des étages 116, 117, 118, 120 et la sortie de l'étage 121 permettent d'effectuer une division par le polynôme $\overline{P_6(X)}$ réciproque du polynôme $P_6(X)$. De même, les circuits de calcul CR1 à CR5 effectuent respectivement des divisions par $\overline{P_1(X)}$, $\overline{P_2(X)}$, $\overline{P_3(X)}$, $\overline{P_4(X)}$ et $\overline{P_5(X)}$.

Par ailleurs, on sait que, dans de tels registres, on peut effectuer une pré-multiplication en appliquant les coefficients d'entrée en divers points des registres. Les circuits CR1 à CR6 sont sont prévus pour effectuer une pré-multiplication par les polynômes $A_1(X)$ à $A_6(X)$ qui sont les réciproques des polynômes dérivés $P'_1(X)$ à $P'_6(X)$. Ainsi le polynôme $P'_3(X)$ est égal à $1+X^2$ et son réciproque est $X^2+1$. Les coefficients d'entrée appliqués à l'entrée EI sont donc fournis à la porte OU exclusif 132, entrée du premier étage 104, pour la multiplication par $1$ et à la porte OU exclusif 133, entrée du troisième étage 106, pour la multiplication par $X^2$. De même, le polynôme $P'_6(X)$ de degré maximum égal à 5 est égal à $X^4$ et son réciproque est X. L'entrée EI est donc reliée à la porte OU exclusif 139, entrée du deuxième étage 117, pour

EP 0 204 612 B1

la multiplication par X.

Enfin, les coefficients du message d'information M(X) sont appliqués successivement, au rythme d'un signal d'horloge commandant l'ensemble du dispositif de codage, à l'entrée EI dans l'ordre croissant, c'est-à-dire $m_0$, puis $m_1$ ... enfin $m_k$. Grâce à l'utilisation de cet ordre, c'est en fait le polynôme $\overline{M(X)}$ qui est appliqué à l'entrée EI. En définitive, chacun des circuits de calcul Cri effectue donc les opérations de multiplication par $A_i(X)$ et de division par $\overline{P_i(X)}$ du polynôme $\overline{M(X)}$. Dès que le dernier coefficient $m_k$ a été appliqué, on sait que l'on dispose, dans les étages de chaque registre, des coefficients du reste de la division de $\overline{M(X)}$ $A_i(X)$ par le polynôme $\overline{P_i(X)}$. Ces coefficients sont donc les coefficients des blocs $m_i(X)$ selon la relation (1). Ce sont ces coefficients qui sont transférés dès l'impulsion d'horloge suivante dans un registre à décalage de sortie 101' à 121'. Ce registre à décalage transmet ensuite successivement à un ensemble d'émission 100 ces coefficients des divers blocs $m_6(X)$ à $m_1(X)$ dans l'ordre décroissant, $m_5^6$, $m_4^6, \ldots, m_0^6, m_5^5, \ldots \frac{1}{0}$.

Bien entendu l'ensemble 100 peut assurer la transmission par voie radioélectrique ou par tout autre type de liaison.

Le signal transmis est reçu par un ensemble de réception 200 qui extrait les coefficients des blocs du mot de code à *n* bits et les envoie à un registre à décalage d'entrée 201' à 221', ayant une sortie Sc, le coefficient $m_5^{6'}$ étant reçu en premier. Lorsque les *n* coefficients du mot de code ont été introduits dans le registre d'entrée, ils sont transférés en parallèle dans des étages de registre 201 à 221 qui forment avec des portes OU exclusif 230 à 238 des circuits de calcul CR1' à CR6' similaires respectivement aux circuits Cr1 à CR6 du dispositif de codage, les liaisons de contre-réaction linéaire étant en particulier identiques. Les sorties de ces circuits de calcul sont les sorties de leur dernier étage. Dans ces circuits de calcul, on met à profit la propriété que, lorsqu'un registre à contre-réaction linéaire est rebouclé suivant le polynôme $\overline{P_i(X)}$ et qu'on introduit un bit *1* à l'entrée de ce registre, on récupère à la sortie les coefficients successifs du polynôme $R_i(X)$ défini plus haut. En introduisant dans le registre les coefficients du polynôme $m_i'(X)$, on obtient donc à la sortie successivement les coefficients du polynôme $S_i(X) = \overline{m_i'(X)} \, R_i(X)$ dans l'ordre croissant. Grâce au procédé de transmission et au type de code choisi, on utilise dans le dispositif de codage et dans le dispositif de décodage les mêmes registres avec les mêmes rebouclages, ce qui est avantageux pour la réalisation des circuits sous forme intégrée.

Les sorties des divers circuits Cr1' à CR6' sont additionnées par des additionneurs binaires 240 à 243 pour fournir sur la sortie SR les coefficients successifs du polynôme S(X) dans l'ordre croissant.

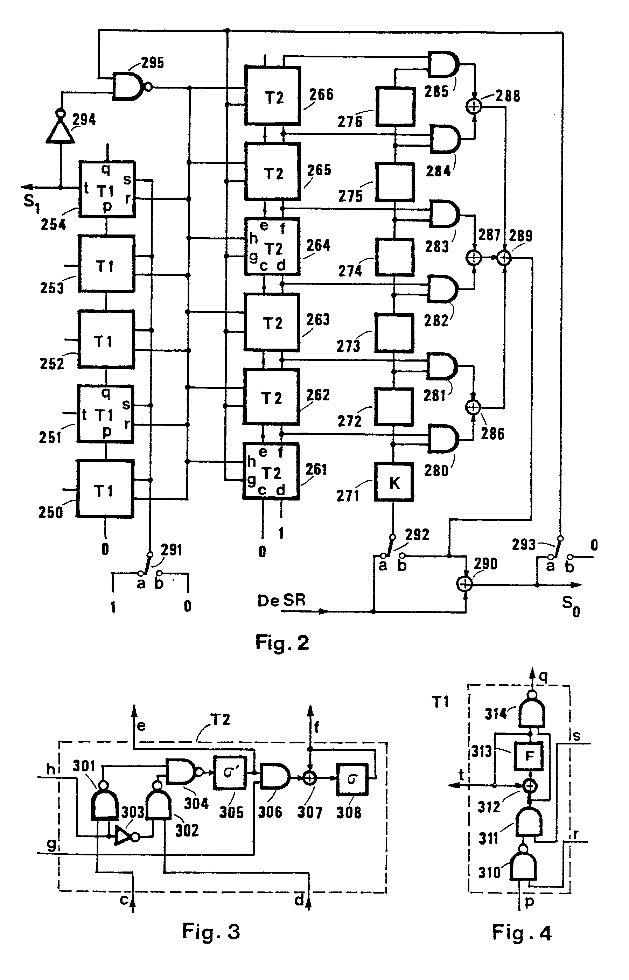

La figure 2 représente un schéma d'un mode de réalisation des circuits de détection et de correction d'erreurs associés du dispositif de décodage selon l'invention.

Dans l'exemple choisi avec n = 21, on a pris *k*, nombre des bits d'information ou bits utiles, égal à 9 et *u*, nombre des bits de redondance ou de test, égal par conséquent à 12.

Les circuits de la figure 2 permettent d'abord le calcul du polynôme σ(X) selon un algorithme de décodage algébrique de Berlekamp-Massey modifié à l'initialisation pour obtenir des structures de circuit parfaitement répétitives.

L'algorithme de Berlekamp-Massey a été décrit par exemple dans un article de J. L. Massey "Shift-register synthesis and BCH decoding" paru dans IEEE Transactions on Information Theory, vol. IT—15, n° 1, janvier 1969, pages 122 à 127. Cet algorithme est destiné à définir le registre à contre-réaction linéaire le plus court de longueur L permettant de fournir une séquence finie de N bits $s_j$ avec des coefficients de contre-réaction $C_i$ (*i* variant entre 1 et L), tel que:

$$s_j + \sum_{i=1}^{L} c_i \, s_{j-i} = 0 \qquad j \geqslant L$$

Or, le calcul du polynôme σ(X), à partir des *u* premiers coefficients $s_i$ du polynôme S(X), est du même type. En conséquence, l'algorithme de calcul utilisé est le suivant. On pose:

$$F = N - 2L$$

où N est le rang du coefficient de S(X) en cours de traitement, L ayant le les mentionné ci-dessus. On voit que, pour N < 2L, on a F < 0 et, pour N ⩾ 2L, on a F ⩾ 0. Cela étant et en substituant σ' à B et σ à C dans l'algorithme connu, on a l'algorithme:

7

1) Initialisation :

$N = 0$   $L = 0$   d'où   $F = 0$        $\sigma(X) = 1$   ($\sigma_0$ est toujours égal à 1)

$\sigma'(X) = 0$   ($\sigma'_0$ est toujours égal à 0)

2) Si $N \geqslant u$, passer à 6). Sinon, calculer :

$$d_N = k_N \oplus \sum_{j=1}^{t_x} \sigma_j \cdot k_{N-j}$$

avec   $t_x = \dfrac{u}{2}$

et       $k_N = s_N$       pour   $0 \leqslant N < u$

et       $k_N = 0$       pour   $N < 0$

3) Si $d_N = 0$   ou   $F < 0$, alors :

pour   $i \geqslant 1$

$$X\sigma'(X) \longrightarrow \sigma'(X)$$
$$\sigma(X) \oplus d_N \sigma'(X) \longrightarrow \sigma(X)$$

c'est-à-dire

$$\begin{cases} \sigma'^{(N+1)}_i \longleftarrow \sigma'^{(N)}_{i-1} \\ \sigma^{(N+1)}_i \longleftarrow \sigma^{(N)}_i \oplus d_N \, \sigma'^{(N)}_i \end{cases}$$

$$F + 1 \longrightarrow F$$

et passer à 5)

4) Si $d_N = 1$ et $F \geqslant 0$, alors :

pour   $i \geqslant 1$

$$X\sigma(X) \longrightarrow \sigma'(X)$$
$$\sigma(X) \oplus \sigma'(X) \longrightarrow \sigma(X)$$

c'est-à-dire

$$\begin{cases} \sigma'^{(N+1)}_i \longleftarrow \sigma^{(N)}_{i-1} \\ \sigma^{(N+1)}_i \longleftarrow \sigma^{(N)}_i \oplus \sigma'^{(N)}_i \end{cases}$$

$$-(F+1) \longrightarrow F$$

et passer à 5)

5) Remplacer $N$ par $N+1$ et retourner à 2)

6) Si $N = n$, arrêt. Sinon, calculer :

$$k_N = \sum_{j=1}^{t_x} \sigma_j \cdot k_{N-j}$$

$$\sigma(X) \longrightarrow \sigma(X) \quad \text{c'est-à-dire} \quad \sigma^{(N+1)}_i \longleftarrow \sigma^{(N)}_i$$

$\sigma'(X)$ et $F$ indifférents

7) Remplacer $N$ par $N+1$ et retourner à 6).

Les étapes 1) à 5) correspondent au calcul du polynôme

$$\sigma(X) = \prod_{\substack{i \text{ en} \\ \text{erreur}}} P_i(X)$$

pendant la fourniture des *u* premiers coefficients du polynôme S(X). Les étapes 6) et 7) correspondent ensuite à la phase de correction des erreurs pendant la fourniture des *k* derniers coefficients du polynôme S(X), période pendant laquelle les coefficients du polynôme σ(X) précédemment calculés doivent être conservés en mémoire.

Le schéma de la figure 2 représente les circuits permettant de mettre en oeuvre cet algorithme et d'effectuer les corrections d'erreurs. Ces circuits comprennent six cellules identiques, 261 à 266, qu'on appellera de type T2, reliées en série pour le calcul des coefficients du polynôme σ(X). Chaque cellule T2 comprend deux entrées de données c, d, deux sorties de données e, f, et deux entrées de commande g, h. Les sorties de données e, f sont connectées respectivement aux entrées c, d de la cellule suivante. Les entrées c, d de la première cellule reçoivent respectivement des niveaux logiques *0* et *1*. Les sorties *f* des cellules T2 sont envoyées respectivement à des portes ET 280 à 285 dont les autres entrées sont connectées aux sorties des étages 271 à 276 d'un registre à décalage K. Les produits en sortie des portes ET sont additionnés à l'aide de portes OU exclusif 286 à 289. La sortie de la porte OU exclusif 289 est reliée à une porte OU exclusif 290 servant également d'additionneur binaire qui reçoit d'autre part les coefficients du polynôme S(X) fournis sur la sortie SR. La sortie de cette porte 290 constitue la sortie $S_0$ du dispositif de décodage.

D'autre part, un compteur commandé formé de cinq cellules identiques, 250 à 254, qu'on appellera de type T1, assure le contrôle de l'unité de calcul binaire de la figure 2. Chaque cellule T1 comporte une entrée *p* et une sortie *q* de mise en série, une sortie d'état *t*, une entrée de blocage *s* et une entrée de commande *r*. Ces moyens de contrôle comportent, en plus du compteur, un inverseur 294 reliant la sortie d'état *t* du dernier étage du compteur à une entrée d'une porte NON—ET 295 dont la sortie est reliée aux entrées de commande *r* des cellules T1 et aux entrées de commande *h* des cellules T2. L'entrée *p* de la première cellule T1 est reliée au niveau logique *0*.

Enfin, des moyens de commande comprenant des commutateurs 291 à 293 sont prévus. Le commutateur 291 relie les entrées de blocage *s* des cellules T1 soit à un niveau logique *1*, soit à un niveau logique *0*. Le commutateur 292 relie l'entrée du registre K, soit à la sortie SR fournissant les coefficients du polynôme S(X), soit à la sortie de la porte OU exclusif 289. Le commutateur 293 relie l'autre entrée de la porte NON—ET 295 et les entrées de commande *g* des cellules T2, soit à la sortie de l'additionneur 290, soit à un niveau logique *0*.

Avant de décrire le fonctionnement de ces circuits, on va d'abord décrire plus en détail la constitution des cellules T1 et T2 en se référant aux figures 4 et 3. Sur la figure 3, on retrouve la cellule T2 avec ses entrées et sorties *s* à *h*. Cette cellule comprend un étage 305 d'un premier registre à décalage σ' et un étage correspondant 308 d'un deuxième registre à décalage σ. Ces étages sont interconnectés par des circuits logiques comprenant trois porte NON—ET 301, 302, 304 et un inverseur 303, qui forment un commutateur reliant l'entrée de l'étage 305 à l'une ou l'autre des entrées *c* et *d* et commandé par l'entrée de commande *h*, et une porte ET 306 dont l'es entrées sont reliées respectivement à la sortie de l'étage 305 et à l'entrée de commande *g* et dont la sortie est connectée à l'entrée de l'étage 308 par l'intermédiaire d'une porte OU exclusif 307 dont l'autre entrée est reliée à la sortie de cet étage 308. Les sorties *e* et *f* de la cellule T2 sont constituées par les sorties des étages 305 et 308 respectivement. Il est clair que, suivant que l'entrée *h* est au niveau logique *1* ou *0*, l'entrée de l'étage 305 est reliée à l'entrée de données *c* ou à l'entrée de données *d*.

D'autre part, la sortie de l'étage 305 est reliée à la porte OU exclusif 307, servant d'additionneur, ou non suivant que l'entrée *g* reçoit un niveau logique *1* ou *0*.

Sur la figure 4, on retrouve la cellule T1 avec ses entrées et sorties *p* à *t*. Cette cellule comporte essentiellement un étage 313 de registre F d'un compteur binaire comptant en complément à 2, c'est-à-dire que le dernier étage contient le bit de signe, *0* pour F ⩾ 0 et *1* pour F < 0. Chaque cellule comprend une porte NON—ET 310 dont les entrées sont reliées aux entrées *p* et *r* de la cellule, une porte ET 311 dont les entrée de blocage *s*, une porte OU exclusif 312 dont les entrées sont reliées à la sortie de la porte ET 311 et à la sortie de l'étage 313 et dont la sortie est connectée à l'entrée de cet étage et une porte NON—ET 314 dont les entrées sont connectées à la sortie de l'étage 313 et à la sortie de la porte ET 311 et dont la sortie constitue la sortie *q* de la cellule. La sortie d'état *t* de la cellule est constituée par la sortie de l'étage 313. Il est clair que, lorsque l'entrée de blocage *s* est au niveau *0*, la porte ET 311 ne transmet qu'un niveau *0* et que l'étage 313 conserve donc son état à chaque impulsion d'horloge commandant cet étage. Si l'entrée *s* est au niveau logique *1*, suivant que l'entrée de commande *r* est au niveau logique *1* ou *0*, l'étage 313 recopie l'état de l'entrée *p* (comptage normal F+1→F) ou bien le contenu de l'étage 313 est inversé [—(F+1)→F], chaque étage 313 ayant une entrée "Clear" de remise à zéro pour l'initialisation.

Après ces précisions sur les cellules T1 et T2, on va pouvoir indiquer le fonctionnement des circuits de la figure 2. Pendant la fourniture des *u* premiers coefficients par la sortie SR, c'est-à-dire pendant les *u* premières impulsions d'horloge, les commutateurs 291 à 293 sont en position a. Les cellules T1 du compteur sont débloquées.

Les sorties $f$ des cellules T2 fournissent les coefficients contenus dans le deuxième registre $\sigma$ et le registre K reçoit successivement les coefficients $s_N$ du polynôme S(X). Les portes ET 280 à 285 effectuant les produits et les portes OU exclusif 286 à 289 effectuant les sommes permettent d'obtenir à la sortie de la porte OU exclusif 289 la quantité

$$\sum_{j=1}^{t_x} \sigma_j \cdot k_{N-j}$$

et, à la sortie de l'additionneur 290, le câblage donnant $\sigma_0 = 1$ en permanence, la valeur

$$d_N = s_N \oplus \sum_{j=1}^{t_x} \sigma_j \cdot k_{N-j} \quad .$$

La valeur de $t$ est au maximum égale à

$$t_x = \frac{U}{2} = 6$$

si le nombre d'erreurs n'est pas supérieur au nombre tolérable pour qu'il puisse y avoir correction et il y a donc six étages au registre K et six cellules T2. Par ailleurs, le nombre $e$ d'étages du compteur, compte tenu de ce que l'on travaille en complément à 2, doit être tel que $2^e \geq 2u$. $e$ donc été choisi égal à cinq.

La valeur de $d_N$ est envoyée par le commutateur 293, d'une part, aux entrées $g$ des cellules T2 et, d'autre part, à l'entrée de la porte NON—ET 295. Si $d_N = 0$ ou si $F < 0$, c'est-à-dire si le bit de signe du dernier étage 254 du compteur vaut $1$, la porte 295 fournit un niveau $1$. Si $d_N = 1$ et $F \geq 0$, alors la porte 295 fournit un niveau $0$. Ainsi l'ensemble des circuits de la figure 2 fonctionne alors selon les étapes 1) à 5) de l'algorithme donné ci-dessus. La valeur $d_N$ est aussi envoyée sur la sortie $S_0$ mais il n'en est pas tenu compte. Après les $u$ premières impulsions d'horloge, le bit de signe dans le compteur doit être $0$ (nombre positif) si le nombre d'erreurs à corriger n'est pas supérieur au nombre tolérable. On obtient ce test sur la sortie $S_1$ de l'étage 254.

Après la fourniture des $u$ premiers coefficients, on passe à la phase de correction des bits utiles. Pour cela, les commutateurs 291 à 293 passent en position $b$. Ceci bloque le compteur de contrôle F par le commutateur 291. Le commutateur 293 applique un niveau logique $0$ sur les entrées $g$ des cellules T2, ce qui permet de conserver en mémoire dans le deuxième registre $\sigma$ les coefficients du polynôme $\sigma(X)$ obtenu, pendant toute la durée de cette seconde phase. Enfin, le commutateur 292 permet de reboucler la sortie de la porte OU exclusif 289 sur l'entrée du troisième registre K. Les circuits de produit et de somme 280 à 289 permettent alors d'obtenir successivement les coefficients $k_i$ de plus fort poids du polynôme de correction K(X) conformément à la relation (4). Ces coefficients sont ajoutés aux coefficients de poids correspondant du polynôme S(X) par l'additionneur binaire 290 et on obtient donc sur la sortie $S_0$ les bits utiles corrigés.

Un avantage du dispositif de décodage selon l'invention est que l'on peut charger le registre d'entrée 201' à 221' (figure 1) avec les blocs du mot de code suivant pendant que l'on traite le mot de code qui vient d'être reçu. On a donc un fonctionnement du type pipe-line qui permet une utilisation efficace de chaque période d'horloge dans tout le dispositif de décodage, sans perte de temps.

Dans tout ce qui précède, on n'a pris en considération que le cas où les blocs reçus contenaient des erreurs. Cependant, on doit aussi envisager le cas des effacements, c'est-à-dire le cas où certains blocs ne sont pas reçus soit par suite d'un "évanouissement" passager du canal de transmission, soit par suite d'une panne, soit par suite d'une élévation temporaire du niveau de bruit ou toute autre cause amenant la disparition d'un certain nombre de blocs. La détection de ces disparitions se fait au niveau de l'ensemble de réception par tout moyen adéquat connu (mesure de bruit sur le canal, bit de parité supplémentaire indiquant une mauvaise réception, etc...).

Pour tenir compte de ces effacements, la solution la plus simple est, au lieu d'initialiser le registre $\sigma$ à $1$, de l'initialiser par le polynôme:

$$\prod_{\substack{i \\ \text{effacé}}} P_i(X)$$

qui est le produit des polynômes $P_i(X)$ correspondant aux blocs effacés. Pour effectuer un tel produit, il faut pour chaque polynôme $P_i(X)$ effectuer une opération $\sigma(X) \leftarrow \sigma(X)\,P_i(X)$, c'est-à-dire $d_i+1$ opérations du type décalage puis addition de $\sigma(X)$ initial. Pour cela, il est possible d'utiliser les circuits permettant la mise en oeuvre de l'algorithme de décodage algébrique déjà décrit. En effet, ces circuits permettent d'effectuer des opérations du type:

$$\begin{cases} \sigma(X) \oplus d\sigma'(X) \longrightarrow \sigma(X) \\ X\sigma'(X) \longrightarrow \sigma'(X) \end{cases} \qquad\qquad \text{I}$$

$$\begin{cases} \sigma(X) \oplus \sigma'(X) \longrightarrow \sigma(X) \\ X\sigma(X) \longrightarrow \sigma'(X) \end{cases} \qquad\qquad \text{II}$$

Si l'on considère un polynôme $P_i(X)$ tel que:

$$P_i(X) = 1 + p_1^i X + p_2^i X + \ldots p_{d_i-1}^i X^{d_i-1} + X^{d_i}$$

les coefficients $p_0^i$ et $p_{d_i}^i$ étant toujours égaux à *1*, pour faire la multiplication $\sigma(X)\,P_i(X)$, on peut effectuer $d_i-1$ opérations du type I avec pour valeurs successives de *d* les valeurs des coefficients $p_1^i$ à $p_{d_i-1}^i$, puis une opération:

$$\begin{cases} \sigma(X) \oplus \sigma'(X) \longrightarrow \sigma(X) \\ X[\sigma(X) \oplus \sigma'(X)] \longrightarrow \sigma'(X) \end{cases} \qquad\qquad \text{III}$$

La première ligne de l'opération III correspond à la multiplication avec le coefficient $p_{d_i}^i$, toujours égal à *1*, et la seconde ligne correspond à l'initialisation du registre $\sigma'$ pour l'opération avec le polynôme $P_{i+1}(X)$ suivant qui a toujours son coefficient $p_0^i$ égal à *1*. Ainsi, la multiplication par le polynôme $P_i(X)$ prend $d_i$ cycles, ce qui est avantageux car cela est égal au nombre $d_i$ de bits effectivement pris en compte.

Tout ceci suppose qu'au début du traitement, $\sigma(X)$ soit initialisé à *1*, ce qui est déjà le cas dans l'algorithme utilisé en liaison avec les circuits de la figure 2, et que $\sigma(X)$ soit initialisé à X, ce qui peut être obtenu facilement en initialisant l'étage 305 de la première cellule T2 à *1* (par exemple par l'entrée "Preset").

Après α cycles si α est le degré du polynôme

$$\sigma_{eff} = \prod_i P_i(X),$$
$$\text{effacé}$$

on disposera donc, dans le deuxième registre, du polynôme $\sigma_{eff}$ pour commencer le décodage selon l'algorithme déjà décrit. La première phase de ce décodage sera donc amputée de α cycles, α étant au plus égal à *u* qui est le maximum tolérable pour les effacements. Le premier registre $\sigma'$ sera, lui, initialisé pour le décodage à $X\sigma_{eff}$, par la dernière opération du type III, ce qui permet un déroulement correct du décodage déjà décrit.

Tout ceci suppose, bien entendu, que l'on soit capable de fournir les coefficients des polynômes $P_i(X)$ effacés et que les circuits de décodage soient en mesure de réaliser non seulement des opérations de types I et II, ce qui est le cas des circuits de la figure 2 mais également des opérations du type III.

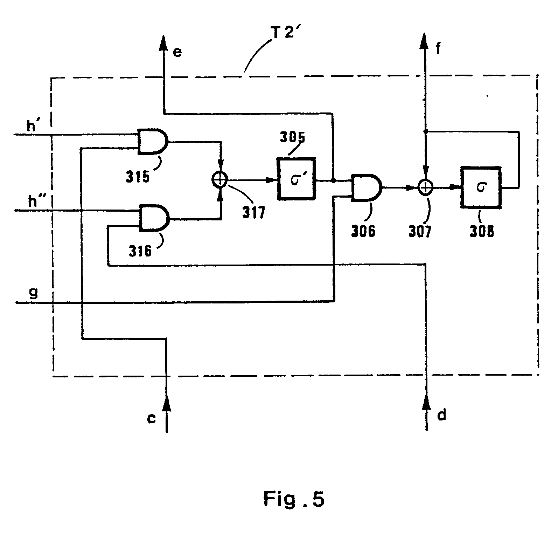

La figure 5 représente la schéma d'une cellule T2' pouvant remplacer les cellules T2 de la figure 2 et capable de réaliser les trois opérations I, II et III. Cette cellule T2' comprend toujours les entrées de données c, d, les sorties de données e, f, l'entrée de commande *g* et les éléments 305 à 308. Mais le commutateur alimentant l'entrée de l'étage 305 est remplacé par un commutateur à trois positions comprenant deux portes ET 315 et 316, ayant chacune une entrée connectée respectivement aux entrées *c* et *d* et une autre entrée relieé respectivement à deux entrées de commande h' et h'' de la cellule, et une porte OU exclusif 317 fournissant la somme modulo 2 des sorties des portes ET 315 et 316 à l'entrée de l'étage 305 du registre $\sigma'$. Suivant les valeurs des niveaux logiques sur les entrées g, h' et h'', la cellule T2' permet d'effectuer les opérations:

$$\text{I} \begin{cases} g = d \\ h' = 1 \\ h'' = 0 \end{cases} \qquad \text{II} \begin{cases} g = 1 \\ h' = 0 \\ h'' = 1 \end{cases} \qquad \text{III} \begin{cases} g = 1 \\ h' = 1 \\ h'' = 1 \end{cases}$$

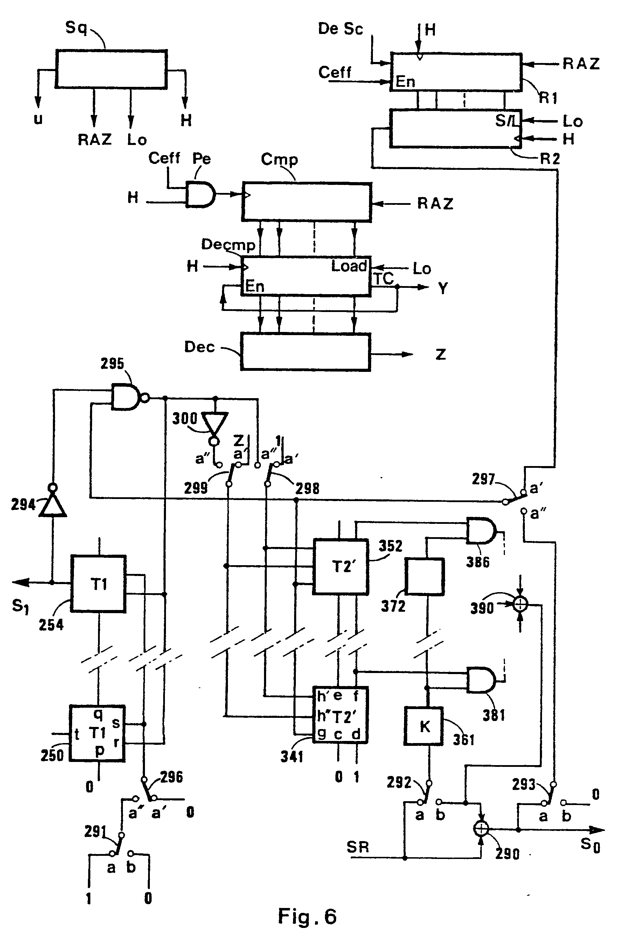

La figure 6 représente un schéma des circuits de détection et de correction d'erreurs et de traitement des effacements selon l'invention. On retrouve l'unité de calcul binaire de la figure 2 avec le compteur à cellules T1, les cellules T2', 341 à 352, remplaçant les cellules T2, le registre K 361 à 372, les circuits binaires de multiplication et somme 381 à 390, l'additionneur 290, l'inverseur 294 et la porte NON—ET 295 et les commutateurs de commande 291 à 293. On utilise $u$ cellules T2' et $u$ étages de registre K au lieu de

$$\frac{u}{2}$$

dans le cas de la figure 2. On y adjoint d'abord des commutateurs de commande supplémentaires 296 à 299 ainsi qu'un inverseur 300. Le commutateur 296 relie les entrées de blocage $s$ des cellules T1 à un niveau logique $0$ de blocage ou au commutateur 291. Le commutateur 297 relie les entrées $g$ des cellules T2' et une entrée de la porte NON—ET 295 soit à des circuits de stockage R1, R2 des coefficients des polynômes $P_i(X)$ correspondant aux blocs effacés, soit au commutateur 293. Le commutateur 298 relie les entrées de commande h' des cellules T2' soit à un niveau logique $1$, soit à la sortie de la porte NON—ET 295. Le commutateur 299 relie les entrées de commande h'' des cellules T2' soit à entrée recevant un signal de commande Z, soit par l'intermédiaire d'un inverseur 300, à la sortie de la porte NON—ET 295. Enfin, il est prévu des circuits de commande supplémentaires comportant une porte ET Pe, un compteur Cmp, un décompteur Decmp, un décodeur Dec et un séquenceur Sq fournissant les signaux de temps H, Lo, RAZ et u. Le compteur Cmp a une entrée de comptage recevant les impulsions d'horloge H par l'intermédiaire de la porte Et Pe, dont l'autre entrée reçoit un signal de commande Ceff, et une entrée de remise à zéro recevant le signal RAZ. Les sorties du compteur sont reliées aux entrées de chargement du décompteur Decmp qui possède une entrée de décomptage recevant les impulsions d'horloge H, une entrée de commande de chargement Load recevant le signal Lo, une sortie de fin de décomptage TC fournissant un premier signal de commande Y changeant de valeur lorsque le décompteur est dans l'état zéro et une entrée d'autorisation En reliée à la sortie TC. Les sorties de bit du décompteur sont connectées aux entrées d'un décodeur Dec dont la sortie fournit un second signal de commande Z prenant le niveau logique $1$ lorsque le décompteur passe par certaines valeurs.

Le fonctionnement de l'ensemble va être décrit en supposant qu'avant le début de la réception de chaque mot de code, on charge le registre d'entrée 201 à 221' (figure 1) avec les coefficients $p_1^i$ à $p_{d_i}^i$ de chacun des polynômes $P_i(X)$ grâce par exemple à un câblage adéquat des entrées "Preset" et "Clear" du registre d'entrée. Ainsi, l'étage 201' contiendra le coefficient $P_1^1, \dots$, les étages 216' à 221' contiendront les coefficients $p_1^6$ à $p_6^6$. Lorsque l'on commence à recevoir les coefficients des blocs $m_i'(X)$ venant de l'ensemble 200, en même temps qu'ils sont introduits dans le registre d'entrée, celui-ci restitue sur sa sortie Sc les coefficients du polynôme $P_i(X)$ correspondant au bloc reçu, dans l'ordre décroissant. Par ailleurs, l'ensemble de réception 200, en même temps qu'il doit transmettre au registre d'entrée un bloc $m_i'(X)$ fournit un signal Ceff indiquant si le bloc est effacé. L'entrée du registre à décalage R1 (figure 6) est reliée à la sortie Sc. Ce registre à décalage de taille égale à $u$, à décalage vers la droite, est décalé au rythme du signal d'horloge général H lorsqu'il y est autorisé par le signal Ceff appliqué sur l'entrée d'autorisation En. Ainsi, ce registre stocke les coefficients des polynômes $P_i(X)$ fournis par la sortie Sc seulement lorsque le signal Ceff lui indique qu'on est en train de recevoir un bloc effacé. A la fin de la mise en mémoire dans le registre d'entrée des $s$ blocs $m_i'(X)$, le séquenceur Sq fournit d'abord un signal Lo, appliqué à l'entrée S/L du registre à décalage R2 et qui autorise le chargement du contenu du registre R1 dans le registre R2 (ainsi d'ailleurs que le transfert du registre d'entrée vers les circuits de calcul CR1' à CR6'), puis un signal RAZ de remise à zéro en particulier du registre R1 qui est ainsi prêt pour la réception du mot de code suivant. Le registre R2 de taille $u$, à décalage vers la gauche, permet de restituer successivement, au rythme de l'horloge H, les coefficients des polynômes $P_i(X)$ correspondant aux blocs effacés, dans l'ordre croissant.

Comme, ainsi qu'on le verra ultérieurement, on peut toujours égaliser les tailles des polynômes de la décomposition de $X^n+1$ effectivement utilisés, on a décrit les circuits de commande dans ce cas simplifié, où tous les polynômes $P_i(X)$ ont le même degré.

Le compteur Cmp compte les impulsions d'horloge H transmises par la porte Pe pendant la durée de chaque bloc effacé, sous la commande du signal Ceff. A la fin de la réception d'un mot de code, son contenu est égal au nombre de coefficients enregistrés dans le registre R1. Ce contenu est chargé dans le décompteur Decmp dont l'entrée de commande de chargement Load reçoit le signal Lo puis le compteur Cmp est remis à zéro par le signal RAZ pour la réception du mot suivant. Au fur et à mesure que les coefficients sont restitués par le registre R2, le décompteur décompte les impulsions d'horloge H jusqu'à ce qu'il revienne à zéro, ce qui correspond à la restitution du dernier coefficient contenu dans le registre R2. La sortie TC du décompteur fournit alors un signal Y qui bloque le décompteur jusqu'à ce qu'une nouvelle valeur soit chargée. Pendant que le décompteur Decmp décompte les impulsions, ses sorties de bit sont décodées par le décodeur Dec qui fournit une impulsion de commande Z chaque fois que le contenu de décompteur est égal à un multiple du degré des polynômes $P_i(X)$.

Dans ces conditions, les commutateurs 296 à 299 sont mis dans la position a' tant que le signal Y indiquant la fin du décomptage n'est pas présent. Ceci bloque le compteur F pendant la période de traitement des effacements, permet la substitution des coefficients fournis par le registre R2 aux valeurs $d_N$ et assure l'envoi d'un niveau logique $1$ sur les entrées de commande h' des cellules T2' et du signal Z sur les entrées h''. Tant que le signal Z est à *O*, les cellules T2' réalisent des opérations du type I et, à chaque dernier coefficient d'un polynôme $P_i(X)$ correspondant à un bloc effacé, le signal Z passant à l'état *1* commande une opération de type III.

Dès que le signal Y indiquant la fin de la phase de calcul du polynôme $\sigma_{eff}$ apparaît, il commande la mise des commutateurs 296 à 299 dans la position a'' et on revient au fonctionnement du dispositif de décodage de la figure 2, les entrées de commande h' et h'' des cellules T2' étant reliées à la sortie de la porte NON—ET 295 directement et par l'intermédiaire de l'inverseur 300 ce qui assure l'exécution d'opérations seulement du type I ou II.

Comme on l'a mentionné, on peut en général toujours se ramener au cas de polynômes $P_i(X)$ de même taille, en regroupant certains des polynômes de plus faible degré pour ramener le degré des facteurs de la décomposition de $X^n+1$ au degré maximum des polynômes $P_i(X)$. Ainsi, pour n = 63 la décomposition donne neuf polynômes ($P_5$ à $P_{13}$) de degré 6, deux ($P_3$ et $P_4$) de degré 3, un ($P_2$) de degré 2 et un ($P_1$) de degré 1. On peut donc regrouper soit le produit $P_3P_4$ soit le produit $R_1P_2P_3$ pour obtenir un polynôme supplémentaire de degré 6. Il reste toujours au moins un polynôme n'ayant pas le même degré que les autres. La solution la plus simple consiste à l'éliminer grâce à un codage assurant que le bloc correspondant est toujours nul, ce qui permet de ne pas le transmettre. Pour cela, il suffit de rajouter au message $\overline{M(X)}$ des bits supplémentaires calculés de telle sorte que le message résultant ainsi complété soit un multiple du polynôme $\overline{P_j}$ à éliminer. Pour cela on effectue un calcul de reste selon la relation:

$$R(X) \equiv \overline{M(X)} \qquad [\overline{P_{j\,\text{élim}}}]$$

et on adjoint ce reste à la suite de $\overline{M(X)}$. Ce calcul s'effectue de manière classique à l'aide d'un registre rebouclé pour effectuer la division par $\overline{P_{j\,\text{élim}}}$.

Les modes de réalisation décrits jusqu'ici et basés sur un algorithme de décodage binaire très proche de l'algorithme de Berlekamp-Massey nécessitent le calcul à chaque cycle d'une quantité

$$\sum_{j=1}^{t} \sigma_j \cdot k_{N-j}$$

et on attend le résultat pour poursuivre le calcul. Or, cette somme de produits est effectué à l'aide d'additionneurs connectés en "arbre" qui limitent donc notablement la vitesse de traitement car, du fait de l'utilisation du résultat pour la suite des calculs en raison d'une contre-réaction, il n'est pas possible d'adopter un fonctionnement du type pipe-line.

Selon une caractéristique de l'invention, on a donc développé un nouvel algorithme, dérivé du précédent, qui se distingue notamment par le fait que l'on distribue les coefficients $s_N$ du polynôme S(X) à toutes les cellules. En prenant des notations similaires et en adoptant quatre registres à décalage $\sigma'$, $\sigma$, $q'$ et q, on utilise l'algorithme:

(avec $1 \leq i \leq u$ pour la détermination des nouvelles valeurs de $\sigma$ et $\sigma'$ et $0 \leq i \leq u\text{-}1$ pour la détermination des nouvelles valeurs d q et q')

1) Initialisation

$$N = 0 \quad L = 0 \quad \text{d'où} \quad F = 0 \qquad \sigma(X) = 1 \qquad \sigma'(X) = 0$$
$$q'(X) = 0 \qquad q(X) = 0$$

2) Si $N \geq u$, passer à 7). Sinon, calculer :

$$d_N = s_N \oplus q_0^{(N)}$$

3) Si $d_N = 0$, alors :

$$X\sigma'(X) \longrightarrow \sigma'(X)$$
$$\sigma(X) \longrightarrow \sigma(X)$$
$$q'(X) \oplus s_N\,\sigma'(X) \longrightarrow q'(X)$$
$$[q(X) \oplus s_N\,\sigma(X)]\,X^{-1} \longrightarrow q(X)$$

c'est-à-dire

$$\sigma_i'^{(N+1)} \longleftarrow \sigma_{i-1}'^{(N)}$$
$$\sigma_i^{(N+1)} \longleftarrow \sigma_i^{(N)}$$
$$q_i'^{(N+1)} \longleftarrow q_i'^{(N)} \oplus s_N\,\sigma_i'^{(N)}$$
$$q_i^{(N+1)} \longleftarrow q_{i+1}^{(N)} \oplus s_N\,\sigma_{i+1}^{(N)}$$

$$F + 1 \longrightarrow F$$

et passer à 6)

13

4) Si $d_N = 1$ et $F < 0$, alors :

$$
\left.
\begin{array}{r}
X\sigma'(X) \longrightarrow \sigma'(X) \\[6pt]
\sigma(X) \oplus \sigma'(X) \longrightarrow \sigma(X) \\[6pt]
q'(X) \oplus s_N \, \sigma'(X) \longrightarrow q'(X)
\end{array}
\right|
\begin{array}{c}
\text{c'est-} \\ \text{à-} \\ \text{dire}
\end{array}
\left|
\begin{array}{r}
\sigma_i'^{(N+1)} \longleftarrow \sigma_{i-1}'^{(N)} \\[6pt]
\sigma_i^{(N+1)} \longleftarrow \sigma_i^{(N)} \oplus \sigma_i'^{(N)} \\[6pt]
q_i'^{(N+1)} \longleftarrow q_i'^{(N)} \oplus s_N \, \sigma_i'^{(N)}
\end{array}
\right.
$$

$$[q(X) \oplus s_N \, \sigma(X)] X^{-1} \oplus [q'(X) \oplus s_N \, \sigma'(X)] X^{-1} \longrightarrow q(X)$$

$$\text{c'est-à-dire} \quad q_i^{(N+1)} \longleftarrow q_{i+1}^{(N)} \oplus s_N \, \sigma_{i+1}^{(N)} \oplus q_{i+1}'^{(N)} \oplus s_N \, \sigma_{i+1}'^{(N)}$$

$$F + 1 \longrightarrow F$$

$$\text{et passer à 6)}$$

5) Si $d_N = 1$ et $F \geqslant 0$, alors :

$$
\left.
\begin{array}{r}
X\sigma(X) \longrightarrow \sigma'(X) \\[6pt]
\sigma(X) \oplus \sigma'(X) \longrightarrow \sigma(X) \\[6pt]
q(X) \oplus s_N \, \sigma(X) \longrightarrow q'(X)
\end{array}
\right|
\begin{array}{c}
\text{c'est-} \\ \text{à-} \\ \text{dire}
\end{array}
\left|
\begin{array}{r}
\sigma_i'^{(N+1)} \longleftarrow \sigma_{i-1}^{(N)} \\[6pt]
\sigma_i^{(N+1)} \longleftarrow \sigma_i^{(N)} \oplus \sigma_i'^{(N)} \\[6pt]
q_i'^{(N+1)} \longleftarrow q_i^{(N)} \oplus s_N \, \sigma_i^{(N)}
\end{array}
\right.
$$

$$[q(X) \oplus s_N \, \sigma(X)] X^{-1} \oplus [q'(X) \oplus s_N \, \sigma'(X)] X^{-1} \longrightarrow q(X)$$

$$\text{c'est-à-dire} \quad q_i^{(N+1)} \longleftarrow q_{i+1}^{(N)} \oplus s_N \, \sigma_{i+1}^{(N)} \oplus q_{i+1}'^{(N)} \oplus s_N \, \sigma_{i+1}'^{(N)}$$

$$-(F+1) \longrightarrow F$$

$$\text{et passer à 6)}$$

6) Remplacer N par N+1 et retourner à 2)

7) Si $N = n$, arrêt. Sinon :

$$k_N = q_0^{(N)}$$

$$
\left.
\begin{array}{r}
\sigma(X) \longrightarrow \sigma(X) \\[6pt]
[q(X) \oplus k_N \, \sigma(X)] X^{-1} \longrightarrow q(X)
\end{array}
\right|
\begin{array}{c}
\text{c'est-} \\ \text{à-} \\ \text{dire}
\end{array}
\left|
\begin{array}{r}
\sigma_i^{(N+1)} \longleftarrow \sigma_i^{(N)} \\[6pt]
q_i^{(N+1)} \longleftarrow q_{i+1}^{(N)} \oplus k_N \, \sigma_{i+1}^{(N)}
\end{array}
\right.
$$

$$\sigma'(X), \; q'(X) \text{ et } F \text{ indifférents}$$

$$\text{et passer à 8)}$$

8) Remplacer N par N+1 et retourner à 7).

Comme dans l'algorithme précédemment utilisé, les premières étapes 1) à 6) correspondent au calcul du polynôme

$$\sigma(X) = \prod_{i \text{ en} \atop \text{erreur}} P_i(X)$$

pendant la fourniture des $u$ premiers coefficients du polynôme S(X). Les étapes 7) et 8) correspondent

14

ensuite à la phase de correction des erreurs pendant la fourniture des $k$ derniers coefficients du polynôme S(X), période pendant laquelle les coefficients du polynôme σ(X) précédemment calculés doivent être conservés en mémoire.

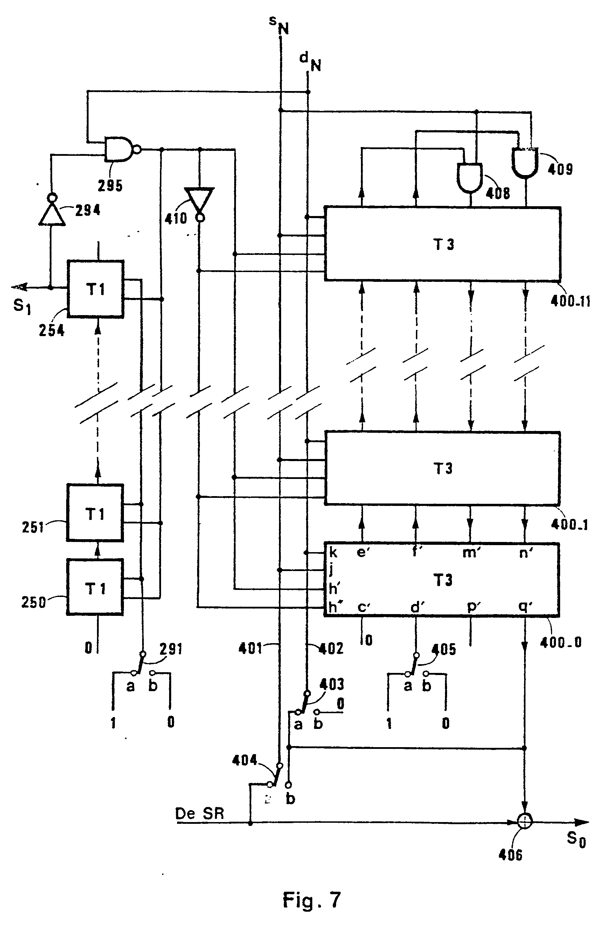

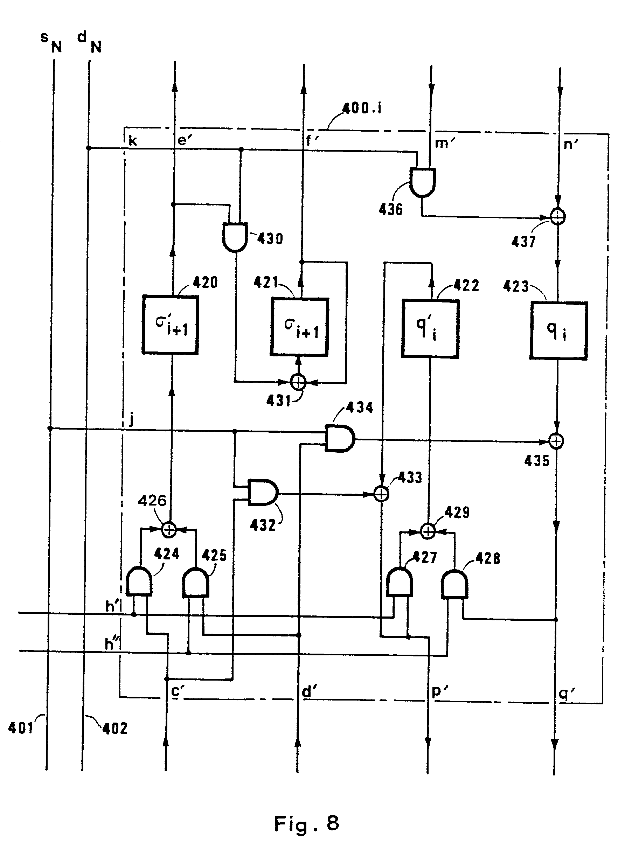

Le schéma de la figure 7 représente les circuits permettant de mettre en oeuvre ce nouvel algorithme et d'effectuer les corrections d'erreur et d'effacement. Ces circuits comprennent u = 12 cellules identiques, 400.0 à 400.11, qu'on appellera de type T3, disposées en cascade. Une cellule de ce type, 400.i est représentée sur la figure 8. Elle comporte quatre étages 420 à 423 appartenant respectivement à quatre registres σ', σ, q' et q. Les quatre étages ne sont pas du même rang. Les étapes 422 et 423 sont de rang $i$ et les étages 420 et 421 sont de rang i+1. $i$ varie entre 0 et u-1. La cellule T3 comporte un premier groupe de deux entrées de donnés c', d' et deux sorties de données e', f', un second groupe de deux entrées de données m', n' et deux sorties de données p', q', deux entrées de commande h', h'' et deux entrées de coefficient j, k. Les entrées des étages 420 et 422 sont reliées chacune à la sortie d'un commutateur à trois positions du même type que celui utilisé dans la cellule T2' de la figure 5. Le commutateur relié à l'étage 420 comporte deux portes ET 424, 425 et une porte OU exclusif 426 et fournit à l'étage 420 soit les données présentes sur l'entrée c', soit les données présentes sur l'entrée d', soit la somme modulo 2 des données sur les deux entrées, selon les niveaux logiques présents sur les entrées de commande h' et h''. Le commutateur relié à l'étage 422 comporte deux portes ET 427, 428 et une porte OU exclusif 429 et fournit à l'étage 422 soit les données présentes à la sortie d'une porte OU exclusif 433, soit les données présentes sur la sortie q' de la cellule, soit la somme modulo 2 des données aux deux entrées du commutateur, selon les niveaux logiques présents sur les entrées de commande h' et h''. La sortie de la porte OU exclusif 433 est également reliée à la sortie p' de la cellule, tandis que ses entrées sont reliées à la sortie de l'étage 422 et à la sortie d'une porte ET 432 dont les entrées sont connectées respectivement aux entrées c' et $j$ de la cellule. La sortie de l'étage 423 est reliée à la sortie q' par l'intermédiaire d'une porte OU exclusif 435 dont l'autre entrée est connectée à la sortie d'un porte ET 434. Celle-ci a ses entrées reliées respectivement aux entrées d' et $j$ de la cellule. L'entrée de l'étage 421 reçoit la sortie d'une porte OU exclusif 431 dont les entrées sont connectées respectivement à la sortie de l'étage 421 et à la sortie d'une porte ET 430 dont les entrées sont reliées à l'entrée $k$ et à la sortie e' de la cellule, cette sortie e' étant elle-même reliée à la sortie de l'étage 420. L'entrée n' de la cellule est reliée à l'entrée de l'étage 423 par l'intermédiaire d'un porte OU exclusif 437 dont l'autre entrée reçoit la sortie d'une porte EU 436. Celle-ci a ses entrées connectées aux entrées m' et $k$ de la cellule. Enfin la sortie f' de la cellule est constituée par la sortie de l'étage 421.

En revenant à la figure 7, on voit que les cellules T3 sont reliées entre elles de manière que les sorties e', f' du premier groupe d'une cellule soient connectées aux entrées c', d' du premier groupe de la cellule suivante, cependant que les sorties p', q' du second groupe de cette cellule suivante sont reliées aux entrées m', n' du second groupe de la cellule en question.

D'autre part, l'entrée c' de la première cellule T3, 400.0, est à niveau logique $0$, l'entrée d' de cette cellule est reliée par un commutateur de commande 405 soit à un niveau $1$ pendant la fourniture des $u$ premiers coefficients de S(X), soit à un niveau $0$ pendant le reste du temps, tandis que la sortie q' de cette première cellule est reliée à l'entrée d'un additionneur binaire 406 (porte OU exclusif) dont la sortie constitue la sortie $S_0$ du dispositif de décodage et dont l'autre entrée reçoit les coefficients $s_N$ du polynôme S(X) fournis par la sortie SR (figure 1). Par ailleurs, il est prévu deux lignes de distribution 401 et 402 connectées respectivement à toutes les entrées $j$ et à toutes les entrées $k$ des cellules T3. Pendant la première phase de calcul de σ(X), c'est-à-dire pendant la fourniture des $u$ premiers coefficients de S(X), la ligne 401 reçoit les coefficients $s_N$ par l'intermediaire d'un commutateur 404 et la ligne 402 reçoit les coefficients calculés $d_N$ de la sortie q' de la première cellule par l'intermédiaire du commutateur 403. Les sorties e', f' de la dernière cellule T3, 400.11, sont rebouclées sur les entrées m', n' de cette cellule par l'intermédiaire de portes ET 408, 409, dont les autres entrées sont reliées à la ligne de distribution 401.

Par ailleurs, les circuits de la figure 7 comportent, comme ceux de la figure 2, le compteur F formé de cellules T1 250 à 254 dont les entrées de blocage s sont reliées au commutateur 291 et dont la sortie d'état $t$ du dernier étage 254 est reliée par l'inverseur 294 à la porte NON—ET 295, l'autre entrée de cette dernière porte étant connectée à la ligne de distribution 402. La sortie de la porte 295 est toujours connectée aux entrées de commande $r$ des cellules T1 et est de plus reliée directement aux entrées h' des cellules T3 et, par l'intermédiaire d'un inverseur 410, aux entrées h'' de ces cellules T3. Pendant la fourniture des $u$ premiers coefficients du polynôme S(X), les commutateurs 291 et 403 à 405 sont dans la position $a$ et les circuits fonctionnement selon les étapes 1) à 6) du nouvel algorithme décrit. Pendant la fourniture des $k$ coefficients suivants de plus fort poids, les commutateurs 291, et 403 à 405 passent dans la position $b$. Le compteur F est bloqué, la seconde ligne de distribution 402 reçoit un niveau logique $0$ et la première ligne de distribution 401 reçoit les coefficients $d_N$ au lieu des coefficients $s_N$, tandis que la sortie $s_0$ fournit les bits utiles corrigés du message M(X), tout ceci conformément aux étapes 7) et 8) du nouvel algorithme.

Il est évident que, comme pour les circuits de la figure 2, ceux de la figure 7 sont adaptables au traitement des effacements en y adjoignant des circuits de commande supplémentaires identiques à ceux de la figure 6, ceci d'autant plus aisément que les cellules T3 sont déjà dotées de commutateurs à trois positions. Il faut, comme dans le cas de la figure 6, initialiser σ(X) à 1 et σ'(X) à X.

L'un des avantages évidents du nouvel algorithme est qu'il remplace le problème du temps de transit dans les circuits binaires arborescents de multiplication et de somme à $u$ entrées par un problème de distribution à $u$ cellules des coefficients $d_N$ et $s_N$, ce qui est reconnu comme un problème nettement plus simple à régler permettant donc d'augmenter très notablement la vitesse de traitement même avec des mots de code de grande longueur.

**Revendications**

1. Procédé de transmission, avec possibilité de correction de paquets d'erreurs, de messages d'information à $k$ éléments binaires à l'aide de mots de code à $n$ éléments binaires constitués de $s$ blocs de taille $d_i$ où $i$ varie de 1 à $s$, $s$ étant le nombre de polynômes $P_i(X)$ d'une décomposition en facteurs de $X^n+1$ sur le corps GF(2) à deux éléments et $d_i$ étant le degré du polynôme $P_i(X)$, ledit procédé étant caractérisé en ce que, à l'émission:

— on calcule, pour chaque bloc constitué par les coefficients d'un polynôme $m_i(X)$, le produit du polynôme $\overline{M(X)}$, réciproque du polynôme $M(X)$ de degré $\leq$ k-1 associé au message à transmettre, par le polynôme $A_i(X)$, réciproque du polynôme $P_i'(X)$ qui est le dérivé du polynôme $P_i(X)$;

— on effectue la division dudit produit par le polynôme $\overline{P_i(X)}$ et on prend comme coefficients du polynôme $m_i(X)$ les coefficients du reste de cette division, selon la relation $m_i(X) \equiv \overline{M(X)} A_i(X) [P_i(X)]$, ces coefficients constituant les éléments binaires du bloc correspondant transmis;
et en ce qu'à la réception:

— on calcule pour chaque bloc reçu un polynôme $S_i(X)$ à $n$ coefficients qui est le produit du polynôme $\overline{m_i'(X)} = X^{d_i-1} m_i'(X^{-1})$ réciproque du polynôme $m_i'(X)$ associé au bloc reçu, par un polynôme de reconstitution

$$R_i(X) = \frac{X^n+1}{P_i(X)},$$

la somme desdits polynômes $S_i(X)$ représentant la superposition du message transmis $X^{n-k}.M(X)$ et d'un syndrome d'erreur;

— on détermine, à l'aide des n-k premiers coefficients de la somme des polynômes $S_i(X)$, les coefficients d'un polynôme $\sigma(X)$, produit des polynômes $P_i(X)$ correspondant aux blocs $i$ en erreur;

— on calcule les $k$ coefficients de poids le plus élevé d'un polynôme $K(X)$ de correction tel que:

$$K(X) \equiv \sum_{j=1}^{s} S_j(X) \quad [X^{n-k}] \quad \text{et} \quad \sum_{m=0}^{t_x} \sigma_m.k_{p-m} = 0$$

$$\text{pour } n-1 \geq p \geq n-k$$

$\sigma_m$ représentant les coefficients du polynôme $\sigma(X)$ de degré maximum $t_x$ autorisé pour une correction valable et $k_{p-m}$ représentant les coefficients du polynôme $K(X)$; et

— on fait la somme de chacun desdits $k$ coefficients de poids le plus élevé de polynôme $K(X)$ avec les coefficients de même poids de la somme des polynômes $S_i(X)$ pour obtenir les $k$ éléments binaires corrigés du message reçu.

2. Procédé selon la revendication 1, caractérisé en ce que la détermination du polynôme $\sigma(X)$ s'effectue en utilisant une variante de l'algorithme de décodage algébrique de Berlekamp-Massey.

3. Dispositif de codage pour la transmission de messages d'information conformément au procédé selon l'une des revendications 1 ou 2, caractérisé en ce qu'il comporte $s$ circuits (CR1 à CR6) de calcul respectivement des $s$ blocs à transmettre, chacun de ces circuits étant constitué d'un registre à contre-réaction linéaire (101, 130; 102, 103, 131; ... ; 116 à 121, 139 à 141) qui reçoit sur sa ou ses entrées lesdits $k$ éléments binaires du message dans l'ordre croissant, la ou lesdites entrées étant disposées de manière à assurer une prémultiplication par le polynôme $A_i(X)$, et dont les connexions de contre-réaction sont disposées de manière à effectuer une division par le polynôme $\overline{P_i(X)}$.

4. Dispositif de codage selon la revendication 3, caractérisé en ce qu'il est prévu des moyens (101' à 121') pour extraire desdits registres (101 à 121) les $n$ éléments binaires du mot de code à transmettre qui sont présents dans lesdits registres dès l'introduction du dernier élément binaire du message.

5. Dispositif de décodage avec correction d'erreurs pour la réception de message d'information transmis conformément au procédé de transmission selon l'une des revendications 1 ou 2, caractérisé en ce qu'il comprend:

— $s$ circuits de calcul (CR1' à CR6') et des moyens (201' à 221') pour leur transférer respectivement les $s$ blocs reçus, ayant pour polynômes associés $m_i'(X)$, pour calculer les coefficients desdits polynômes $S_i(X)$ selon la relation: $S_i(X) = \overline{M_i'(X)} R_i(X)$ où $\overline{m_i'(X)}$ est le polynôme réciproque du polynôme $m_i'(X)$ et où

$$R_i(X) = \frac{X^n+1}{P_i(X)}$$

est le polynôme de reconstitution;

EP 0 204 612 B1

— des moyens additionneurs (240 à 243) pour faire la somme de tous les polynômes $S_i(X)$;

— une unité de calcul binaire (250 à 290, 294, 295) mettant en oeuvre un algorithme de décodage algébrique de Berlekamp-Massey et comportant un premier registre à décalage ($\sigma$, 305) et un deuxième registre à décalage ($\sigma$, 308) interconnectés par des circuits logiques (301 à 304, 306, 307), un troisième registre à décalage (271 à 276), des circuits binaires de multiplication (280 à 285) et de somme (286 à 289) effectuant les produits terme à terme des contenus des deuxième et troisième registres puis la somme de ces produits, un additionneur binaire (290) effectuant l'addition de ladite somme avec le coefficient correspondant du polynôme somme des polynômes $S_i(X)$ et des circuits de contrôle (250 à 254; 294, 295) comprenant un compteur commandé (250 à 254) pour contrôler lesdits circuits logiques;

— des moyens de commande (291 à 293 pour faire fonctionner ladite unité de calcul binaire selon ledit algorithme pendant la durée de la fourniture par lesdits moyens additionneurs (240 à 243) des n-k premiers coefficients à l'additionneur (290) de l'unité de calcul binaire et à l'entrée du troisième registre (271 à 276), de sorte que les coefficients du polynôme $\sigma(X)$, produit des polynômes $P_i(X)$ correspondant aux blocs *i* en erreur, soient présents dans le deuxième registre à la fin de ladite durée, et pour faire fonctionner ensuite ladite unité en calculateur des coefficients de plus fort poids du polynôme de correction K(X) selon la relation:

$$\sum_{m=0}^{t_x} \sigma_m \cdot k_{p-m} = 0 \qquad \text{pour } n-1 \geq p \geq n-k$$

où $k_{p-m}$ représente les coefficients du polynôme K(X) et $\sigma_m$ ceux du polynôme $\sigma(X)$ de degré maximum $t_x$, lesdits moyens de commande assurant le maintien des coefficients $\sigma_m$ dans le second registre pendant toute la durée de fourniture des *k* coefficients de plus fort poids du polynôme somme des polynômes $S_i(X)$ et assurant l'envoi de la somme de sortie des circuits binaires de somme (286 à 289) de l'unité de calcul binaire sur l'entrée dudit troisième registre.

6. Dispositif de décodage selon la revendication 5, caractérisé en ce que lesdits circuits logiques (301 à 304, 306, 307) sont constitués de manière à former, avec les étages corresponds (305, 308) des premier et deuxième registres, des cellules identiques (T2), comportant deux entrées de données (c, d), deux sorties de données (e, f) et deux entrées de commande (g, h), et comprennent, pour chaque cellule (T2), un commutateur (301 à 304) à deux entrées reliées respectivement aux entrées (c, d) de la cellule, une sortie reliée à l'entrée de l'étage (305) du premier registre et une entrée de commande reliée à la seconde entrée de commande (h) de la cellule, et une porte ET (306) reliant la sortie de l'étage du premier registre à l'entrée de l'étage correspondant (308) du second registre par l'intermédiaire d'une porte OU exclusif (307) dont l'autre entrée est reliée à la sortie dudit étage du second registre, l'entrée de commande de ladite porte (306) étant reliée à la première entrée de commande (g) de la cellule (T2) et les sorties des étages (305, 308) du premier et du second registre étant reliées respectivement aux sorties (e, f) de la cellule, et en ce que les sorties (e, f) de chaque cellule sont reliées respectivement aux entrées de données (c, d) de la cellule suivante, les entrées de données (c, d) de la première cellule (261) recevant respectivement des niveaux logiques *0* et *1*.

7. Dispositif de décodage selon la revendication 6, caractérisé en ce que ledit compteur commandé (250 à 254) des circuits de contrôle de l'unité de calcul binaire est constitué de *e* étages (T1) en série, où *e* est tel que $2^e \geq 2(n-k)$, le dernier étage (254) fournissant l'élément binaire de signe en complément à 2 et chaque étage (T1) ayant une entrée de mise en série (p), une sortie de mise en série (q), une sortie d'état (t) de l'étage, une entrée de blocage (s) et une entrée de commande (r) pour commander soit le comptage normal, soit l'inversion de l'élément binaire contenu dans l'étage, en ce que lesdits circuits de contrôle comprennent en outre une porte NON—ET (295), dont une entrée est reliée par un inverseur (294) à la sortie d'état (t) du dernier étage (254) du compteur, dont la seconde entrée est reliée à toutes les premières entrées de commande (g) des cellules (T2) de l'unité de calcul binaire et dont la sortie est reliée aux secondes entrées de commande (h) desdites cellules et aux entrées de commande (r) des étages (T1) du compteur, et en ce que lesdits moyens de commande comprennent des commutateurs (291, 292, 293) pour, pendant les n-k premiers coefficients des polynômes $S_i(X)$, appliquer un niveau logique de déblocage aux entrées de blocage (s) des étages du compteur, raccorder l'entrée du troisième registre (271 à 276) à l'entrée recevant les coefficients de la somme des polynômes $S_i(X)$ et raccorder la sortie de l'additionneur binaire (290) de l'unité de calcul binaire aux premières entrées de commande (g) de toutes les cellules (261 à 266) et à la seconde entrée de la porte NON—ET (295), et pour, pendant les *k* derniers coefficients des polynômes $S_i(X)$, appliquer un niveau logique de blocage aux entrées de blocage (s) des étages du compteur, raccorder l'entrée du troisième registre à la sortie somme des circuits binaires de somme (286 à 289) de l'unité de calcul binaire et raccorder les premières entrées de commande (g) des cellules et la seconde entrée de la porte NON—ET à un niveau logique *0*.

8. Dispositif de décodage avec correction d'erreurs et traitement des blocs effacés selon l'une quelconque des revendications 5 à 7, caractérisé en ce que lesdits circuits logiques de l'unité de calcul binaire sont constitués de manière à former, avec les étages correspondants (305, 308) des premier et deuxième registres, des cellules identiques (T2'), comportant deux entrées de données (c, d), deux sorties

17

EP 0 204 612 B1

de données (e, f) et trois entrées de commande (g, h', h'') et comprennent pour chaque cellule (T2'), un commutateur à trois positions (315 à 317) comportant deux entrées reliées aux deux entrées de données (c, d) de la cellule, deux entrées de commande reliées aux deuxième et troisième entrées de commande (h', h'') de la cellule et une sortie reliée à l'entrée de l'étage (305) du premier registre et fournissant soit l'un ou l'autre des coefficients présents sur les entrées de données (c, d) de la cellule, soit leur somme binaire suivant les niveaux logiques appliqués aux entrées de commande.

9. Dispositif de décodage avec correction d'erreurs pour la réception de messages d'information transmis conformément au procédé de transmission selon la revendication 1, caractérisé en ce qu'il comprend:

— $s$ circuits de calcul (CR1' à CR6') et des moyens (201' à 221') pour leur transférer respectivement les $s$ blocs reçus, ayant pour polynômes associés $m_i'(X)$, pour calculer les coefficients desdits polynômes $S_i(X)$ selon la relation:

$$S_i(X) = \overline{mS_i(X)} \, RS_i(X) \text{ où } \overline{mS_i(X)}$$

est le polynôme réciproque du polynôme $mS_i(X)$ et où

$$R_i(X) = \frac{X44^{+1}}{P_i(X)}$$

est le polynôme de reconstitution;

— des moyens additionneurs (240 à 243) pour faire la somme de tous les polynômes $S_i(X)$;

— une unité de calcul binaire (250 à 254, 294, 295, 400.0 à 400.11, 401, 402, 406, 408 à 410) mettant en oeuvre un algorithme de décodage dérivé de l'algorithme de Berlekamp-Massey et comportant un premier registre à décalage ($\sigma'$, 420) et un deuxième registre à décalage ($\sigma$, 421) interconnectés par des premiers circuits logiques (424 à 426, 430, 431), un troisième registre à décalage (q', 422) et un quatrième registre à décalage (q, 423) interconnectés entre eux et avec les premier et deuxième registres par des seconds circuits logiques (427 à 429, 432 à 437), un additionneur binaire (406) effectuant l'addition du coefficient ($d_N$) présent à la sortie du dernier étage du quatrième registre avec le coefficient correspondant du polynôme somme des polynômes $S_i(X)$, des portes ET (408, 409) pour appliquer aux entrées du premier étage des troisième et quatrième registres respectivement le produit des sorties du dernier étage des premier et deuxième registres d'une part par les coefficients successifs du polynôme somme des polynômes $S_i(X)$ pendant la durée de fourniture des n-k premiers coefficients et d'autre part par ledit coefficient ($d_N$) de sortie du quatrième registre, pendant la fourniture des $k$ derniers coefficients, et des circuits de contrôle (250 à 254; 294, 295, 410) comprenant un compteur commandé (250 à 254) pour contrôler lesdits circuits logiques;

— des moyens de commande (291, 403 à 405) pour faire fonctionner ladite unité de calcul binaire selon ledit algorithme pendant la durée de la fourniture des n-k premiers coefficients par le quatrième registre, de sorte que les coefficients du polynôme $\sigma(X)$, produit des polynômes $P_i(X)$ correspondant aux blocs $i$ en erreur, soient présents dans le deuxième registre à la fin de ladite durée, et pour faire fonntionner ensuite ladite unité en calculateur des coefficients de plus fort poids du polynôme de correction $K(X)$ selon la relation:

$$\sum_{m=0}^{t_x} \sigma_m \cdot k_{p-m} = 0 \quad \text{pour } n-1 \geqslant p \geqslant n-k$$

où $k_{p-m}$ représente les coefficients du polynôme $K(X)$ et $\sigma_m$ ceux du polynôme $\sigma(X)$ de dregé maximum $t_x$, les coefficients $k_i$ successifs étant fournis à la sortie du quatrième registre et lesdits moyens de commande assurant le maintien des coefficients $\sigma_m$ dans le second registre pendant toute la durée de fourniture des $k$ coefficients de plus fort poids du polynôme somme des polynômes $S_i(X)$.

10. Dispositif de décodage selon la revendication 9, caractérisé en ce que l'unité de calcul binaire est réalisée de manière qu'au moment d'indice N+1 (N < n-k), les coefficients qui s'inscrivent dans les étages d'indice $i$ des premier à quatrième registres soient donnés par les relations suivantes:

A) Si $d_N = 0$

$$\sigma_i'^{(N+1)} \longleftarrow \sigma_{i-1}'^{(N)} \quad \text{et} \quad \sigma_i^{(N+1)} \longleftarrow \sigma_i^{(N)}$$

$$q_i'^{(N+1)} \longleftarrow q_i'^{(N)} \oplus s_N \, \sigma_i'^{(N)}$$

$$q_i^{(N+1)} \longleftarrow q_{i+1}^{(N)} \oplus s_N \, \sigma_{i+1}^{(N)}$$

B) Si $d_N = 1$ et $F < 0$

$$\sigma_i'^{(N+1)} \longleftarrow \sigma_{i-1}'^{(N)} \quad \text{et} \quad \sigma_i^{(N+1)} \longleftarrow \sigma_i^{(N)} \oplus \sigma_i'^{(N)}$$

$$q_i'^{(N+1)} \longleftarrow q_i'^{(N)} \oplus s_N \, \sigma_i'^{(N)}$$

$$q_i^{(N+1)} \longleftarrow q_{i+1}^{(N)} \oplus s_N \, \sigma_{i+1}^{(N)} \oplus q_{i+1}'^{(N)} \oplus s_N \, \sigma_{i+1}'^{(N)}$$

C) Si $d_N = 1$ et $F \geqslant 0$

$$\sigma_i'^{(N+1)} \longleftarrow \sigma_{i-1}^{(N)} \quad \text{et} \quad \sigma_{i.}^{(N+1)} \longleftarrow \sigma_i^{(N)} \oplus \sigma_i'^{(N)}$$

$$q_i'^{(N+1)} \longleftarrow q_i^{(N)} \oplus s_N \, \sigma_i^{(N)}$$

$$q_i^{(N+1)} \longleftarrow q_{i+1}^{(N)} \oplus s_N \, \sigma_{i+1}^{(N)} \oplus q_{i+1}'^{(N)} \oplus s_N \, \sigma_{i+1}'^{(N)}$$

où $d_N$ est le coefficient fourni à la sortie du quatrième registre, F est le nombre inscrit dans le compteur (250 à 254) des circuits de contrôle, et $i$ varie de 1 à n-k pour la détermination de σ et σ' et de 0 à n-k-1 pour la détermination de q et q'.

11. Dispositif de décodage selon l'une des revendications 9 ou 10, carctérisé en ce que lesdits premiers et seconds circuits logiques (424 à 426, 430, 431; 427 à 429, 432 à 437) sont constitués de manière à former, avec les étages de rang i+1 des premier et deuxième registres et les étages de rang $i$ des troisième et quatrième registres où $i$ varie de 0 à n-k-1, des cellules identiques (T3, 400.0 à 400.11), comportant un premier groups de deux entrées de données (c', d') et deux sorties de données (e', f') pour les premier et deuxième registres, un second groupe de deux entrées de données (m,', n') et deux sorties de données (p', q') pour les troisième et quatrième registres, deux entrées de commande (h', h'') et deux entrées de coefficient (j, k) reliées à des lignes de distribution communes (401, 402), et comprennent, pour chaque cellule (T3):

— un premier commutateur à trois positions (424 à 426) comportant deux entrées reliées aux premières entrées de données (c', d') de la cellule, deux entrées de commande reliées aux entrées de commande (h', h'') de la cellule et une sortie reliée à l'entrée de l'étage (420) du premier registre et fournissant, soit l'un ou l'autre des coefficients présents sur les premières entrées (c', d') de la cellule, soit leur somme binaire suivant les niveaux logiques appliqués aux entrées de commande;

— une première porte ET (430) reliant la sortie de l'étage du premier registre à l'entrée de l'étage correspondant (421) du deuxième registre par l'intermédiaire d'une porte OU exclusif (431) dont l'autre entrée est reliée à la sortie dudit étage du deuxième registre, l'autre entrée de la porte ET (430) étant reliée à la seconde entrée de coefficient (k) de la cellule et les sorties des étages (420, 421) du premier et du deuxième registre étant reliées respectivement aux premières sorties de données (e', f') de la cellule;

— second commutateur à trois positions (427 à 429) comportant deux entrées reliées aux secondes sorties de données (p', q') de la cellule, deux entrées de commande reliées aux entrées de commande (h', h'') de la cellule et une sortie reliée à l'entrée de l'étage (422) du troisième registre et fournissant, soit l'un ou l'autre des coefficients présents sur les secondes sorties (p', q') de la cellule, soit leur somme binaire suivant les niveaux logiques appliqués aux entrées de commande;

— une deuxième porte ET (432) reliée à l'entrée de données (c'), associée au premier registre, et à la première entrée de coefficient (j) de la cellule et dont la sortie est connectée à une entrée d'une porte OU exclusif (433) ayant son autre entrée connectée à la sortie de l'étage du troisième registre (422) et sa sortie reliée à la sortie de données (p') du second groupe, associée au troisième registre;

— une troisième porte ET (436) reliant l'entrée de données (m') du second groupe, associée au troisième registre, à l'entrée de l'étage correspondant (423) du quatrième registre par l'intermédiaire d'un porte OU exclusif (437) dont l'autre entrée est reliée à l'entrée de données (n') du second groupe, associée au quatrième registre, l'autre entrée de la porte ET (436) étant reliée à la seconde entrée de coefficient (k) de la cellule; et

— une quatrième porte ET (434) reliant l'entrée de données (d') du premier groupe, associée au deuxième registre, à la sortie de données (q') du second groupe, associée au quatrième registre, par l'intermédiaire d'un porte OU exclusif (435) dont l'autre entrée est connectée à la sortie de l'étage correspondant (423) du quatrième registre, l'autre entrée de la quatrième porte ET (434) étant reliée à la première entrée de coefficient (j) de la cellule;

et en ce que les entrées de données (c', d') du premier groupe et les sorties de données (p', q') du second groupe d'une cellule quelconque (400.i) sont connectées respectivement aux sorties de données (e', f') du premier groupe et aux entrées de données (m', n') du second groupe de la cellule précédente [400.(i-1)], les sorties de données (e', f') du premier groupe et les entrées de données (m', n') du second groupe de la dernière cellule (400.11) étant interconnectées par les portes ET (408, 409) de l'unité de calcul binaire, la sortie de données (q') du second groupe de la première cellule (400.0) étant reliée à l'additionneur binaire (406) de l'unité de calcul binaire et l'entrée de données (c') du premier groupe de cette première cellule recevant un niveau logique 0.

12. Dispositif de décodage selon la revendication 11, caractérisé en ce que ledit compteur commandé (250 à 254) des circuits de contrôle de l'unité de calcul binaire est constitué de e étages (T1) en série, où e est tel que $2^e \geqslant 2(n-k)$, le dernier étage (254) fournissant l'élément binaire de signe en complément à 2 et chaque étage (T1) ayant une entrée de mise en série (p), une sortie de mise en série (q), une sortie d'état (t) de l'étage, une entrée de blocage (s) et une entrée de commande (r) pour commander soit le comptage normal, soit l'inversion de l'élément binaire contenu dans l'étage, en ce que lesdits circuits de contrôle comprennent en outre une porte NON—ET (295), dont une entrée est reliée par un inverseur (294) à la sortie d'état (t) du dernier étage (254) du compteur, dont la seconde entrée est reliée à la seconde ligne de distribution commune (402) connectée à toutes les secondes entrées de coefficient (k) des cellules (T3) de l'unité de calcul binaire et dont la sortie est reliée directement à toutes les entrées de commande (r) des étages (T1) du compteur et à toutes les premières entrées de commande (h') des cellules (T3) et, par l'intermédiaire d'un inverseur (410), à toutes les secondes entrées de commande (h'') desdites cellules, et en ce que lesdits moyens de commande comprennent des commutateurs (291, 403 à 405) pour, pendant la fourniture des n-k premiers coefficients des polynômes $S_i(X)$, appliquer un niveau logique de déblocage aux entrées de blocage (s) des étages du compteur, raccorder la première ligne de distribution commune (401) à la sortie (SR) fournissant les coefficients du polynôme somme des polynômes $S_i(X)$, raccorder la seconde ligne de distribution commune (402) à la sortie de données (q'), associée au quatrième registre, de la première cellule (400.0) et appliquer un niveau logique 1 à l'entrée de données (d') de cette cellule, associée au deuxième registre, et pour, pendant les k derniers coefficients des polynômes $S_i(X)$, appliquer un niveau logique de blocage aux entrées de blocage (s) des étages du compteur, raccorder la première ligne de distribution (401) à la sortie de données (q'), associée au quatrième registre, de la première cellule (400.0), appliquer un niveau logique 0 à la seconde ligne de distribution (402) et appliquer un niveau logique 0 à l'entrée de données (d') de cette cellule, associée au deuxième registre.

13. Dispositif de décodage selon l'une quelconque des revendications 5 à 7, 9 à 12, caractérisé en ce que lesdits s circuits de calcul (CR1' à CR6') comprennent chacun un registre à contre-réaction linéaire (201; 202, 203, 230 ; . . . ; 216 à 221, 236 à 238) dont les connexions de contre-réaction sont disposées de manière à effectuer une division par le polynôme $\overline{P_i(X)}$, réciproque du polynôme $P_i(X)$.

14. Dispositif de décodage selon l'une quelconque des revendications 5 à 7, 9 à 13, caractérisé en ce que chaque étage (T1) du compteur comprend une porte NON—ET (310) dont les entrées sont reliées respectivement à l'entrée de données (p) et à l'entrée de commande (r) de l'étage, une porte ET (311) dont les entrées sont reliées respectivement à la sortie de la porte NON—ET (310) et à l'entrée de blocage (s) de l'étage, une porte OU exclusif (312) reliée à la sortie de la porte ET, un étage de registre (313) dont l'entrée est reliée à la sortie de la porte OU exclusif (312) et dont la sortie est reliée à la sortie d'état (t) de l'étage (T1) et à l'autre entrée de la porte OU exclusif (312), et une porte NON—ET (314) dont les entrées sont connectées respectivement aux sorties de l'étage de registre (313) et de la porte ET (311) et dont la sortie constitue la sortie (q) de l'étage l'entrée de données (p) du premier étage du compteur recevant un niveau logique 0.

15. Dispositif de décodage avec correction d'erreurs et traitement des blocs effacés selon l'une quelconque des revendications 8 à 14, caractérisé en ce qu'il comprend:

— des premiers moyens (R1, R2) pour stocker en mémoire et restituer pendant le traitement ultérieur les coefficients, relatifs aux termes de degré supérieur ou égal à un, de tous les polynômes $P_i(X)$ associés aux blocs effacés, dans l'ordre de leur réception;

— des deuxièmes moyens (Cmp, Decmp, Dec, Pe, Sq) pour fournir un premier signal de commande (Y) de durée égale au temps nécessaire aux premiers moyens pour restituer tous les coefficients de polynômes effacés correspondant au mot de code en cours de traitement et un second signal de commande (Z) passant au niveau logique 1 pendant la fourniture par lesdits premiers moyens du dernier coefficient, associé au terme de degré le plus élevé, de chaque polynôme $P_i(X)$ correspondant à un bloc effacé; et

— des troisièmes moyens (296 à 299) de contrôle pour, pendant la durée du premier signal de commande (Y) et dès la fourniture du premier coefficient ($s_0$) sur l'entrée de l'unité de calcul binaire, contrôler le fonctionnement de l'unité de calcul binaire, à partir desdits signaux de commande (Y, Z), de telle sorte qu'à la fin du premier signal de commande (Y), on dispose dans le deuxième registre ($\sigma$, 308; $\sigma$, 421) des coefficients du polynôme $\sigma_{eff}(X)$ égal au produit des polynômes $P_i(X)$ correspondant aux blocs effacés, ce polynôme $\sigma_{eff}(X)$ servant de contenu initial du deuxième registre pour la suite du fonctionnement selon l'algorithme de décodage.

16. Dispositif de décodage selon la revendication 15, caractérisé en ce que lesdits troisièmes moyens comprennent:

— un premier commutateur (296) pour appliquer une tension de blocage sur les entrées de blocage (s) des cellules (T1) du compteur de contrôle pendant la durée du premier signal de commande (Y) et pour connecter ces entrées au commutateur (291) des moyens de commande de l'unité de calcul binaire pendant le reste du temps;

— un deuxième commutateur (297) pour remplacer, pendant la durée du premier signal de commande (Y), les coefficients ($d_N$), fournis à la porte NON—ET (295) et aux premières entrées de commande (g) des cellules (T2') ou aux secondes entrées de coefficient (k) des cellules (T3), par les coefficients restitués par lesdits premiers moyens; et

— un troisième et un quatrième commutateur (298, 299) pour appliquer aux entrées de commande (h', h'') des cellules T2', T3), pendant la durée du premier signal de commande (Y), respectivement un signal ayant le niveau logique **1** et un signal ayant le niveau logique du second signal de commande (Z) et, pendant le reste du temps, respectivement le signal de sortie de la porte NON—ET (295) et son complément fourni par un inverseur (300; 410), le premier registre étant initialisé à la valeur X et le deuxième registre à la valeur *1* au début de chaque cycle de traitement d'un mot de code.

## Patentansprüche

1. Verfahren, um mit der Möglichkeit einer Korrektur von Fehlerpaketen Informationsnachrichten aus $k$ binären Elementen mittels Code-Wörtern aus $n$ binären Elementen zu übertragen, welche aus $s$ Blöcken einer Größe $d_i$ gebildet sind, in welchen $i$ von 1 bis $s$ variiert, wobei $s$ die Zahl der Polynome $P_i(X)$ einer Zerlegung in Faktoren von $X^n+1$ über den Körper GF(2) mit zwei Elementen ist und $d_i$ der Grad des Polynoms $P_i(X)$ ist, wobei dieses Verfahren dadurch gekennzeichnet ist, daß bei der Aussendung:

— für jeden durch die Koeffizienten eines Polynoms $m_i(X)$ gebildeten Block das Produkt des Polynoms $\overline{M(X)}$, das zu dem Polynom M(X) des Grads $\leq$ k-1, das der zu übertragenden Nachricht zugeordnet ist, reziprok ist, mit dem Polynom $A_i(X)$, das zu dem Polynom $P'_i(X)$ reziprok ist, das von dem Polynom $P_i(X)$ abgeleitet ist, berechnet wird;

— die Teilung des genannten Produktes durch das Polynom $\overline{P_i(X)}$ durchgeführt wird und als Koeffizienten des Polynoms $m_i(X)$ die Koeffizienten des Rests dieser Teilung gemäß der Beziehung $m_i(X) \equiv \overline{M(X)}\ A_i(X)\ [P_i(X)]$ genommen werden, wobei diese Koeffizienten die binären Elemente des übertragenen, entsprechenden Blocks bilden; und daß bei dem Empfang:

— für jeden empfangenen Block ein Polynom $S_i(X)$ mit $n$ Koeffizienten berechnet wird, das das Produkt des Polynoms $\overline{m'_i(X)} = X^{d_i-1}m'_i\ (X^{-1})$ ist, das zu dem Polynom $m'_i(X)$, das dem erhaltenen Block zugeordnet ist, reziprok ist, mit einem Wiederherstellungs-Polynom $R_i(X) = X^n+1/P_i\ (X)$, wobei die Summe der genannten Polynome $S_i(X)$ die Überlagerung der übertragenen Nachricht $X^{n-k}.M(X)$ mit einem Fehlersyndrom darstellt;

— mittels der n-k ersten Koeffizienten der Summe der Polynome $S_i(X)$ die Koeffizienten eines Polynoms $\sigma(X)$ festgelegt werden, das das Produkt der Polynome $P_i(X)$, die den Fehler-Blökken *i* entsprechen, ist;

— die $k$ Koeffizienten mit dem höchsten Gewicht eines Korrektur-Polynoms K(X) berechnet werden, so daß:

$$K(X) \equiv \sum_{j=1}^{s} S_j(X)\ [X^{n-k}] \quad \text{und} \quad \sum_{m=0}^{t_x} \sigma_m \cdot k_{p-m} = 0$$

$$\text{für } n-1 \geq p \geq n-k$$

worin $\sigma_m$ die Koeffizienten des Polynoms $\sigma(X)$ des maximalen Grads $t_x$ darstellt, der für eine gültige Korrektur zugelassen ist, und $k_{p-m}$ die Koeffizienten des Polynoms K(X) darstellt; und

— die Summe jedes der genannten $k$ Koeffizienten mit dem höchsten Gewicht des Polynoms K(X) mit den Koeffizienten eines selben Gewichts der Summe der Polynome $S_i(X)$ berechnet wird, um die $k$ binären, korrigierten Elemente der empfangenen Nachricht zu erhalten.

2. Verfahren nach Anspruch 1, dadurch gekennzeichnet, daß die Bestimmung des Polynoms $\sigma(X)$ durch Verwendung einer Variante des Algorithmus zum algebraischen Dekodieren von Berlekamp-Massey erfolgt.

3. Vorrichtung zum Kodieren für die Übertragung von Informationsnachrichten gemäß dem Verfahren nach Anspruch 1 oder 2, dadurch gekennzeichnet, daß sie $s$ Schaltungen (CR1 bis CR6) zum Berechnen der jeweiligen $s$ zu übertragendenen Blöcke umfaßt, wobei jede dieser Schaltungen aus einem Register (101, 130; 102, 103, 131; . . . ; 116 bis 121, 139 bis 141) mit linearer Gegenkopplung besteht, das an seinem Eingang bzw. an seinen Eingängen die genannten $k$ binären Elemente der Nachricht in ansteigender Reihenfolge empfängt, wobei der Eingang bzw. die Eingänge so angeordnet ist bzw. sind, daß eine Vormultiplikation mit dem Polynom $A_i(X)$ gewährleistet wird, und dessen Gegenkopplung-Anschlüsse so angeordnet sind, daß eine Teilung durch das Polynom $\overline{P_i(X)}$ erfolgt.

4. Vorrichtung zum Kodieren nach Anspruch 3, dadurch gekennzeichnet, daß Mittel (101' bis 121') zum Entnehmen der $n$ binären Elemente des zu übertragenden Codeworts aus den Registern (101 bis 121) vorgesehen sind, die in diesen Registern gleich nach der Einführung des letzten binären Elements der Nachricht vorhanden sind.

5. Vorrichtung zum Dekodieren mit Fehlerkorrektur für den Empfang der übertragenen Informationsnachrichten gemäß dem Verfahren zur Übertragung nach Anspruch 1 oder 2, dadurch gekennzeichnet, daß sie umfaßt:

— $s$ Rechenschaltungen (CR1' bis CR6') sowie Mittel (201' bis 221'), um ihnen jeweils die $s$ empfangenen Blöcke zu übertragen, die als zugeordnete Polynome $m'_i(X)$ aufweisen, um die Koeffizienten dieser Polynome $S_i(X)$ gemäß der Beziehung: $S_i(X) = \overline{m'_i(X)} R_i(X)$ zu berechnen, worin $\overline{m'_i(X)}$ das zu dem Polynom $m'_i(X)$ reziproke Polynom ist und worin $R_i(X) = X^n + 1/P_i(X)$ das Wiederherstellungs-Polynom ist;

— Addiermittel (240 bis 243), um die Summe aller Polynome $S_i(X)$ zu bilden;

— eine binäre Recheneinheit (250 bis 290, 294, 295), welche einen Algorithmus zu algebraischen Dekodieren von Berlekamp-Massey anwendet und ein erstes Schieberegister ($\sigma'$, 305) sowie ein zweites Schieberegister ($\sigma$, 308), die durch logische Schaltungen (301 bis 304, 306, 307) miteinander verbunden sind, ein drittes Schieberegister (271 bis 276), binäre Schaltungen zum Multiplizieren (280 bis 285) und zum Summieren (286 bis 289) umfaßt, welche die Produkte Glied für Glied der Inhalte des zweiten Registers sowie des dritten Registers und dann die Summe dieser Produkte berechnen, einen binären Addieren (290), der die Addition dieser Summe zu dem entsprechenden Koeffizient des Polynoms aus der Summe der Polynome $S_i(X)$ ausführt, sowie Steuerschaltungen (250 bis 254; 294, 295) umfaßt, die einen gesteuerten Zähler (250 bis 254) für die Steuerung dieser logischen Schaltungen umfaßt;

— Steuermittel (291 bis 293), um die genannte binäre Recheneinheit gemäß dem genannten Algorithmus während der Dauer der Lieferung der n-k ersten Koeffizienten durch die genannten Addiermittel (240 bis 243) an den Addierer (290) der binären Recheneinheit und an den Eingang des dritten Registers (271 bis 276) arbeiten zu lassen, so daß die Koeffizienten des Polynoms σ(X) aus dem Produkt der Polynome $P_i(X)$, die den fehlerbehafteten $i$ Blöcken entsprechen, nach Beendigung dieser Dauer in dem zweiten Register vorhanden sind, und um dann die genannte Einheit zur Berechnung der das größe Gewicht aufweisenden Koeffizienten des Korrektur-Polynoms K(X) arbeiten zu lassen, gemäß der

$$\text{Beziehung:} \quad \sum_{m=0}^{t_x} \sigma_m \cdot k_{p-m} = 0 \quad \text{für } n-1 \geq p \geq n-k,$$

worin $k_{p-m}$ die Koeffizienten des Polynoms K(X) und $\sigma_m$ diejenigen des Polynoms σ(X) des maximalen Grades $t_x$ darstellt, wobei die genannten Steuermittel das Verbleiben der Koeffizienten $\sigma_m$ in dem zweiten Register während der ganzen Dauer der Lieferung der $k$ das größte Gewicht aufweisenden Koeffizienten des Polynoms aus der Summe der Polynome $S_i(X)$ darstellt, sowie das Senden der Ausgangssumme der binären Summier-Schaltungen (286 bes 289) der binären Recheneinheit an den Eingang des genannten dritten Registers gewährleisten.

6. Vorrichtung zum Dekodieren nach Anspruch 5, dadurch gekennzeichnet, daß die genannten logischen Schaltungen (301 bis 304, 306, 307) so ausgelegt sind, daß sie mit den entsprechenden Stufen (305, 308) des ersten Registers und des zweiten Registers identische Zellen (T2) bilden, die zwei Daten-Eingänge (c, d), zwei Daten-Ausgänge (e, f) sowie zwei Steuer-Eingänge (g, h) umfassen und für jede Zelle (T2) einen Umschalter (301 bis 304) mit zwei Eingängen umfassen, die jeweils mit den Eingängen (c, d) der Zelle verbunden sind, wobei ein Ausgang mit dem Eingang der Stufe (305) des ersten Registers und ein Steuereingang mit dem zweiten Eingang (h) zur Steuerung der Zelle, sowie ein AND-Gate (306), das den Ausgang der Stufe des ersten Registers mit dem Eingang der entsprechenden Stufe (308) des zweiten Registers mittels eines EXCLUSIV-OR-Gates (307) verbindet, dessen anderer Eingang mit dem Ausgang der genannten Stufe des zweiten Registers verbunden ist, wobei der Eingang zur Steuerung des genannten Gates (306) mit dem ersten Eingang (g) zur Steuerung der Zelle (T2) und die Ausgänge der Stufen (305, 308) des ersten Registers sowie des zweiten Registers mit den jeweiligen Ausgängen (e, f) der Zelle verbunden sind, und daß die Ausgänge (e, f) jeder Zelle jeweils mit den Daten-Eingängen (c, d) der folgenden Zelle verbunden sind, wobei die Daten-Eingänge (c, d) der ersten Zelle (261) jeweils logische Pegel 0 und 1 empfangen.

7. Vorrichtung zum Dekodieren nach Anspruch 6, dadurch gekennzeichnet, daß der genannte gesteuerte Zähler (250 bis 254) der Schaltungen zur Steuerung der binären Recheneinheit aus $e$ in Reihe geschalteten Stufen (T1) besteht, worin $e$ derart ist, daß $2^e \geq 2(n-k)$ ist, wobei die letzte Stufe (254) das binäre Vorzeichenelement als Komplement zu 2 liefert, und jede Stufe (T1) einen Eingang zur seriell-Umsetzung (p), einen Ausgang zur seriell-Umsetzung (q), einen Ausgang für den Zustand (t) der Stufe, einen Blockier-Eingang (s) sowie einen Steuereingang (r) umfaßt, um entweder das normale Zählen oder die Invertierung des in der Stufe enthaltenen binären Elements zu steuern, daß die genannten Steuerschaltungen ferner ein NAND-Gate (295) umfassen, wovon ein Eingang durch einen Inverter (294) mit dem Ausgang für den Zustand (t) der letzten Stufe (254) des Zählers verbunden ist und wovon der zweite Eingang mit allen ersten Eingängen zur Steuerung (g) der Zellen (T2) der binären Recheneinheit verbunden ist, und wovon der Ausgang mit den zweiten Eingängen zur Steuerung (h) der genannten Zellen und mit den eingängen zur Steuerung (r) der Stufen (T1) des Zählers verbunden ist, und daß die genannten Steuermittel Umschalter (291, 292, 293) umfassen, um während der n-k ersten Koeffizienten der Polynome $S_i(X)$

22

einen logischen Entsperrpegel an die Eingänge zum Blockieren (s) der Stufen des Zählers anzulegen, den Eingang des dritten Registers (271 bis 276) an den Eingang anzuschließen, der die Koeffizienten der Summe der Polynome $S_i(X)$ empfängt, und den Ausgang des binären Addierers (290) der binären Recheneinheit mit den ersten Eingängen zur Steuerung (g) aller Zellen (261 bis 266) sowie mit dem zweiten Eingang des NAND-Gates (295) zu verbinden, und um während der $k$ letzten Koeffizienten der Polynome $S_i(X)$ einen logischen Sperrpegel an die Eingänge zum Blockieren (s) der Stufen des Zählers anzulegen, den Eingang des dritten Registers an den Summenausgang der binären Summier-Schaltungen (286 bis 289) der binären Recheneinheit sowie die ersten Eingänge zur Steuerung (g) der Zellen und den zweiten Eingang des NAND-Gates auf einen logischen Pegel $0$ zu legen.

8. Vorrichtung zum Dekodieren mit Fehlerkorrektur und Verarbeitung der gelöschten Blöcke nach einem der Ansprüche 5 bis 7, dadurch gekennzeichnet, daß die genannten logischen Schaltungen der binären Recheneinheit so ausgelegt sind, daß sie mit den entsprechenden Stufen (305, 308) des erstens Registers sowie des zweiten Registers identische Zellen (T2') bilden, die zwei Daten-Eingänge (c, d), zwei Daten-Ausgänge (e, f) sowie drei Steuereingänge (g, h', h'') umfassen, und für jede Zelle (T2') einen dreistelligen Umschalter (315 bis 317) umfassen, welcher zwei mit den beiden Daten-Eingängen (c, d) der Zelle verbundene Steuereingänge sowie einen Ausgang umfaßt, der mit dem Eingang der Stufe (305) des ersten Registers verbunden ist und entweder den einen oder den anderen der an den Daten-Eingängen (c, d) der Zelle vorhandenen Koeffizienten oder deren binäre Summe liefert, je nach den logischen Pegeln, die an die Steuereingänge angelegt sind.

9. Vorrichtung zum Dekodieren mit Fehlerkorrektur für die Übertragung von Informationsnachrichten, die gemäß dem Verfahren zur Übertragung nach Anspruch 1 übertragen werden, dadurch gekennzeichnet, daß sie umfaßt:

$s$ Rechenschaltungen (CR1' bis CR6') sowie Mittel (201' bis 221'), um ihnen jeweils die $s$ empfangenen Blöcke zu übertragen, die als zugeordnete Polynome $m'_i(X)$ haben, um die Koeffizienten dieser Polynome $S_i(X)$ gemäß der Beziehung: $S_i(X) = \overline{m'_i(X)} \, R_i(X)$ zu berechnen, worin $\overline{m'_i(X)}$ das zu dem Polynom $m'_i(X)$ reziproke Polynom ist und worin $R_i(X) = X^n + 1/P_i(X)$ das Wiederherstellungs-Polynom ist;

— Addiermittel (240 bis 243), um die Summe aller Polynome $S_i(X)$ zu bilden;

— eine binäre Recheneinheit (250 bis 254, 294, 295, 400.0 bis 400.11, 401, 402, 406, 408 bis 410), die einen Algorithmus zum algebraischen Dekodieren anwendet, welcher von dem Algorithmus von Berlekamp-Massey abgeleitet ist, und ein erstes Schieberegister ($\sigma'$, 420) sowie ein zweites Schieberegister ($\sigma$, 421) umfaßt, die durch erste logische Schaltungen (424 bis 426, 430, 431) miteinander verbunden sind, sowie ein drittes Schieberegister (q', 422) und ein viertes Schieberegister (q, 423) umfaßt, welche miteinander, mit dem ersten Register sowie mit dem zweiten Register über zweite logische Schaltungen (427 bis 429, 432 bis 437) verbunden sind, sowie einen binären Addierer (406) umfaßt, der die Addition des Koeffizienten ($d_N$), der an dem Ausgang der letzten Stufe des vierten Registers vorhanden ist, zu dem entsprechenden Koeffizient des Polynoms aus der Summe der Polynome $S_i(X)$ durchführt, AND-Gates (408, 409) umfaßt, um an die Eingänge der erste Stufe des dritten Registers bzw. des vierten Registers das Produkt der Ausgänge der letzten Stufe des ersten Registers und des zweiten Registers einerseits mit den aufeinanderfolgenden Koeffizienten des Polynoms, das die Summe der Polynome $S_i(X)$ ist, während der Dauer der Lieferung der n-k ersten Koeffizienten und andererseits mit den genannten Koeffizienten ($d_N$) am Ausgang des vierten Registers, während der Lieferung der $k$ letzten Koeffizienten anzulegen, sowie Steuerschaltungen (250 bis 254; 294, 295, 410) umfaßt, die einen gesteuerten Zähler (250 bis 254) umfassen, um die genannten logischen Schaltungen zu steuern;

— Steuermittel (291, 403 bis 405), um die genannte binäre Recheneinheit gemäß dem genannten Algorithmus während der Dauer der Lieferung der n-k ersten Koeffizienten durch das vierte Register arbeiten zu lassen, so daß die Koeffizienten des Polynoms $\sigma(X)$ aus dem Produkt der Polynome $P_i(X)$, die den fehlerbehafteten $i$-Blöcken entsprechen, nach Beendigung der genannten Dauer in dem zweiten Register vorhanden sind, und um dann die genannte Einheit zur Berechnung der das höchste Gewicht aufweisenden Koeffizienten des Korrektur-Polynoms K(X) arbeiten zu lassen, gemäß der Beziehung:

$$\sum_{m=0}^{t_x} \sigma_m \cdot k_{p-m} = 0 \quad \text{für } n-1 \geq p \geq n-k$$

worin $k_{p-m}$ die Koeffizienten des Polynoms K(X) und $\sigma_m$ diejenigen des Polynoms $\sigma(X)$ des maximalen Grades $t_x$ darstellen, wobei die aufeinanderfolgenden Koeffizienten $k_i$ an den Ausgang des vierten Registers abgegeben werden, und die genannten Steuermittel das Verbleiben der Koeffizienten $\sigma_m$ in dem zweiten Register während der gesamten Dauer der Lieferung der $k$ Koeffizienten des höchsten Gewichts in dem Polynom aus der Summe der Polynome $S_i(X)$ gewährleisten.

10. Vorrichtung zum Dekodieren nach Anspruch 9, dadurch gekennzeichnet, daß die binäre Recheneinheit so ausgelegt ist, daß zum Zeitpunkt des Indexes N+1 (N< n-k) die Koeffizienten, die in den Stufen des ersten Registers sowie des vierten Registers vom Index $i$ eingeschrieben werden, durch die folgenden Beziehungen gegeben sind:

A) Wenn $d_N = 0$

$$\sigma_i'^{(N+1)} \longleftarrow \sigma_{i-1}'^{(N)} \quad \text{und} \quad \sigma_i^{(N+1)} \longleftarrow \sigma_i^{(N)}$$

$$q_i'^{(N+1)} \longleftarrow q_i'^{(N)} \oplus s_N \, \sigma_i'^{(N)}$$

$$q_i^{(N+1)} \longleftarrow q_{i+1}^{(N)} \oplus s_N \, \sigma_{i+1}^{(N)}$$

B) Wenn $d_N = 1$ und $F < 0$

$$\sigma_i'^{(N+1)} \longleftarrow \sigma_{i-1}'^{(N)} \quad \text{und} \quad \sigma_i^{(N+1)} \longleftarrow \sigma_i^{(N)} \oplus \sigma_i'^{(N)}$$

$$q_i'^{(N+1)} \longleftarrow q_i'^{(N)} \oplus s_N \, \sigma_i'^{(N)}$$

$$q_i^{(N+1)} \longleftarrow q_{i+1}^{(N)} \oplus s_N \, \sigma_{i+1}^{(N)} \oplus q_{i+1}'^{(N)} \oplus s_N \, \sigma_{i+1}'^{(N)}$$

C) Wenn $d_N = 1$ und $F \geq 0$

$$\sigma_i'^{(N+1)} \longleftarrow \sigma_{i-1}^{(N)} \quad \text{und} \quad \sigma_i^{(N+1)} \longleftarrow \sigma_i^{(N)} \oplus \sigma_i'^{(N)}$$

$$q_i'^{(N+1)} \longleftarrow q_i^{(N)} \oplus s_N \, \sigma_i^{(N)}$$

$$q_i^{(N+1)} \longleftarrow q_{i+1}^{(N)} \oplus s_N \, \sigma_{i+1}^{(N)} \oplus q_{i+1}'^{(N)} \oplus s_N \, \sigma_{i+1}'^{(N)}$$

worin $d_N$ der am Ausgang des vierten Registers gelieferte Koeffizienten ist, F die in dem Zähler (250 bis 254) eingeschriebene Anzahl der Steuerschaltungen ist, und *i* von 1 bis n-k für die Bestimmung von σ und σ' und von 0 bis n-k-1 für die Bestimmung von q und q' variiert.

11. Vorrichtung zum Dekodieren nach Anspruch 9 oder 10, dadurch gekennzeichnet, daß die ersten sowie die zweiten logischen Schaltungen (424 bis 426, 430, 431; 427 bis 429, 432 bis 437) so ausgebildet sind, daß sie mit den Stufen der Rangordnung i+1 des ersten Registers und des zweiten Registers sowie mit den Stufen der Rangordnung *i* des dritten Registers und des vierten Registers, in welchen *i* von 0 bis n-k-1 variiert, identische Zellen (T3, 400.0 bis 400.11) bilden, die umfassen: eine erste Gruppe zweier Dateneingänge (c', d') sowie zweier Datenausgänge (e', f') für das erste Register und für das zweite Register, eine zweite Gruppe zweier Dateneingänge (m', n') und zweier Datenausgänge (p', q') für das dritte Register und für das vierte Register, sowie zwei Steuereingänge (h', h'') und zwei Koeffizient-Eingänge (j, k), welche mit gemeinsamen Verteilungsleitungen (401, 402) verbunden sind, und für jede Zelle (T3) umfassen:

— einen ersten Umschalter mit drei Stellungen (424 bis 426), der zwei mit den ersten Dateneingängen (c', d') der Zelle verbundenen Eingänge, zwei mit den Eingängen (h', h'') zur Steuerung der Zelle verbundene Steuereingänge sowie einen mit dem Eingang der Stufe (420) des ersten Registers verbundenen Ausgang umfaßt, und entweder den einen oder den anderen der an den ersten Eingängen (c', d') der Zelle vorhandenen Koeffizienten oder deren binäre Summe gemäß den an den Steuereingängen angelegten logischen Pegeln liefert;

— ein erstes AND-Gate (430), das den Ausgang der Stufe des ersten Registers mit dem Eingang der entsprechenden Stufe (421) des zweiten Registers über ein EXCLUSIV-OR-Gate (431) verbindet, dessen anderer Eingang mit dem Ausgang der Stufe des zweiten Registers verbunden ist, wobei der andere Eingang des AND-Gates (430) mit dem zweiten Koeffizienten-Eingang (k) der Zelle, und die Ausgänge der Stufen (420, 421) des ersten Registers sowie des zweiten Registers mit den jeweiligen ersten Datenausgängen (e', f') der Zelle verbunden sind;

— einen zweiten Umschalter mit drei Stellungen (427 bis 429), der zwei mit den zweiten Datenausgängen (p', q') der Zelle verbundene Eingänge, zwei mit den Eingängen (h', h'') zur Steuerung der Zelle verbundene Steuereingänge sowie einen mit dem Eingang der Stufe (422) des dritten Registers verbundenen Ausgang umfaßt und entweder den einen oder den anderen der an den zweiten Ausgängen (p', q') der Zelle vorhandenen Koeffizienten oder deren binäre Summe liefert, je nach den an die Steuereingänge angelegten logischen Pegeln;

— ein zweites AND-Gate (432), das mit dem dem ersten Register zugeordneten Dateneingang (c') und mit dem ersten Koeffizient-Eingang (j) der Zelle verbunden ist und dessen Ausgang mit einem Eingang eines EXCLUSIV-OR-Gates (433) verbunden ist, wovon der andere Eingang mit dem Ausgang der Stufe des dritten Registers (422) und sein Ausgang mit dem Datenausgang (p') der zweiten Gruppe, der dem dritten Register zugeordnet ist, verbunden ist;

— ein drittes AND-Gate (436), das den Dateneingang (m') der zweiten Gruppe, der dem dritten Register zugeordnet ist, mit dem Eingang der entsprechenden Stufe (423) des vierten Registers über ein EXCLUSIV-OR-Gate (437) verbindet, wovon der andere Eingang mit dem Dateneingang (n') der zweiten Gruppe der dem vierten Register zugeordnet ist, verbunden ist, wobei der andere Eingang des AND-Gates (436) mit dem zweiten Eingang des Koeffizients (k) der Zelle verbunden ist; und

— ein viertes AND-Gate (434), das den Dateneingang (d') der ersten Gruppe, der dem zweiten Register zugeordnet ist, mit dem Datenausgang (q') der zweiten Gruppe, der dem vierten Register zugeordnet ist, über ein EXCLUSIV-OR-Gate (435) verbindet, dessen anderer Eingang mit dem Ausgang der entsprechenden Stufe (423) des vierten Registers verbunden ist, wobei der andere eingang des vierten AND-Gates (434) mit dem ersten Eingang des Koeffizients (j) der Zelle verbunden ist; und dadurch gekennzeichnet, daß die Dateneingänge (c', d') der ersten Gruppe sowie die Datenausgänge (p', q') der zweiten Gruppe einer beliebigen Zelle (400.i) jeweils mit den Dateneingängen (e', f') der ersten Gruppe sowie mit den Dateneingängen (m', n') der zweiten Gruppe der vorausgehenden Zelle [400.(i-1)] verbunden sind, wobei die Datenausgänge (e', f') der ersten Gruppe sowie die Dateneingänge (m', n') der zweiten Gruppe der letzten Zelle (400.11) durch die AND-Gates (408, 409) der binären Recheneinheit miteinander verbunden sind, wobei der Datenausgang (q') der zweiten Gruppe der ersten Zelle (400.0) mit dem binären Addierer (406) der binären Recheneinheit verbunden ist und der Dateneingang (c') der ersten Gruppe dieser ersten Zelle einen logischen Pegel 0 bekommt.

12. Vorrichtung zum Dekodieren nach Anspruch 11, dadurch gekennzeichnet, daß der genannte gesteuerte Zähler (250 bis 254) der Schaltungen zur Steuerung der binären Recheneinheit aus $e$ in Serie geschalteten Stufen (T1) besteht, worin $e$ derart ist, daß $2^e \geq 2(n-k)$ ist, wobei die letzte Stufe (254) das binäre Vorzeichenelement als Komplement zu 2 liefert und jede Stufe (T1) einen Eingang zum seriell-Umsetzung (p), einen Ausgang zum seriell- Umsetzung (q), einen Ausgang für den Zustand (t) der Stufe, einen Eingang zum Blockieren (s) sowie einen Steuereingang (r) zur Steuerung entweder des normalen Zählens oder der Invertierung des in der Stufe enthaltenen binären Elements aufweist, daß die genannten Steuerschaltungen ferner ein NAND-Gate (295) umfassen, wovon ein Eingang über einen Inverter (294) mit dem Ausgang für den Zustand (t) der letzten Stufe (254) des Zählers verbunden ist, und dessen zweiter Eingang mit der zweiten gemeinsamen Verteilungsleitung (402) verbunden ist, die mit allen zweiten Eingängen des Koeffizienten (k) der Zellen (T3) der binären Recheneinheit verbunden ist, und dessen Ausgang unmittelbar mit allen eingangen zu Steuerung (r) der Stufen (T1) des Zählers sowie mit allen ersten Eingängen zur Steuerung (h') der Zellen (T3), und über einen Inverter (410) mit allen zweiten Eingängen zur Steuerung (h'') dieser Zellen verbunden ist, und daß die genannten Steuermittel Umschalter (291, 403 bis 405) umfassen, um während der Lieferung der n-k ersten Koeffizienten der Polynome $S_i(X)$ einen logischen Entsperrpegel an die Eingänge zum Blockieren (s) der Stufen des Zählers anzulegen, die erste gemeinsame Verteilungsleitung (401) mit dem Datenausgang (SR) zu verbinden, der die Koeffizienten des Polynoms aus der Summe der Polynome $S_i(X)$ liefert, die zweite gemeinsame Verteilungsleitung (402) mit dem Datenausgang (q') der ersten Zelle (400.0) der dem vierten Register zugeordnet ist, zu verbinden und an den Dateneingang (d') dieser Zelle, der dem zweiten Register zugeordnet ist, einen logischen Pegel 1 anzulegen sowie während der $k$ letzten Koeffizienten der Polynome $S_i(X)$ einen logischen Sperrpegel an die Eingänge zum Blockieren (s) der Stufen des Zählers anzulegen, die erste Verteilungsleitung (401) mit den Datenausgang (q') der ersten Zelle (400.0) zu verbinden, der dem vierten Register zugeordnet ist, einen logischen Pegel 0 an die zweite Verteilungsleitung (402) sowie einen logischen Pegel 0 an den Dateneingang (d') dieser Zelle, der dem zweiten Register zugeordnet ist, anzulegen.

13. Vorrichtung zum Dekodieren nach einem der Ansprüche 5 bis 7, 9 bis 12, dadurch gekennzeichnet, daß jede der $s$ Rechenschaltungen (CR1' bis CR6') ein Register mit linearer Gegenkopplung (201; 202, 203, 230; ... 216 bis 221, 236 bis 238) aufweist, dessen Gegenkopplungsanschlüsse so angeordnet sind, daß sie eine Teilung durch das Polynom $\overline{P_i(X)}$ ausführen, das zu dem Polynom $P_i(X)$ reziprok ist.

14. Vorrichtung zum Dekodieren nach einem der Ansprüche 5 bis 7, 9 bis 13, dadurch gekennzeichnet, daß jede Stufe (T1) des Zählers umfaßt: ein NAND-Gate (310), dessen Eingänge jeweils mit dem Dateneingang (p) und dem Eingang zur Steuerung (r) der Stufe verbunden sind, ein AND-Gate (311), dessen Eingänge jeweils mit dem Ausgang des NAND-Gates (310) und mit dem Eingang zum Blockieren (s) der Stufe verbunden sind, ein EXCLUSIV-OR-Gate (312), das mit dem Ausgang des AND-Gates verbunden ist, eine Registerstufe (313), deren Eingang mit dem Ausgang des EXCLUSIV-OR-Gates (312) und deren Ausgang mit dem Ausgang für den Zustand (t) der Stufe (T1) und mit dem anderen Eingang des EXCLUSIV-OR-Gates (312) verbunden sind, sowie ein NAND-Gate (314), dessen Eingänge jeweils mit den Ausgängen der Stufen des Registers (313) und des AND-Gates (311) verbunden sind und dessen Ausgang den Ausgang

EP 0 204 612 B1

(q) der Stufe bildet, wobei der Dateneingang (p) der ersten Stufe des Zählers einen logischen Pegel *0* erhält.

15. Vorrichtung zum Dekodieren, mit Fehlerkorrektur und Verarbeitung der gelöschten Blöcke nach einem der Ansprüche 8 bis 14, dadurch gekennzeichnet, daß sie umfaßt:

— erste Mittel (R1, R2), um die Koeffizienten, welche sich auf die Terme des Grades eins oder höher beziehen, aller Polynome $P_i(X)$, die den gelöschten Blöcken zugeordnet sind, in der Folge ihres Empfangs zu speichern und während der späteren Verarbeitung wiederzugeben;

— zweite Mittel (Cmp, Decmp, Dec, Pe, Sq), um ein erstes Steuersignal (Y) einer Dauer abzugeben, die für die ersten Mittel notwendig ist, um alle Koeffizienten der gelöschten Polynome, welche dem gerade verarbeiteten Codewort entsprechen, wiederzugeben, sowie um ein zweites Steuersignal (Z) abzugeben, das den logischen Pegel *1* während der Lieferung des letzten Koeffizienten durch die genannten ersten Mittel annimmt, der dem Term mit dem höchsten Grad in jedem Polynom $P_i(X)$ zugeordnet ist, das einem gelöschten Block entspricht; und

— dritte Steuermittel (296 bis 299), um während der Dauer des ersten Steuersignals (Y) und gleich bei der Lieferung des ersten Koeffizienten ($s_0$) an dem Eingang der binären Recheneinheit die Funktionsweise dieser Einheit ausgehend von den genannten Steuersignalen (Y, Z) zu steuern, so daß am Ende des ersten Steuersignals (Y) Koeffizienten des Polynoms $\sigma_{eff}(X)$, das dem Produkt der Polynome $P_i(X)$ gleich ist, das den gelöschten Blöcken entspricht, in dem zweiten Register ($\sigma$, 308; $\sigma$, 421) angeordnet werden, wobei dieses Polynom $\sigma_{eff}(X)$ als Anfangsinhalt des zweiten Registers für die Folge der Arbeitsweise gemäß dem Algorithmus zum Dekodieren dient.

16. Vorrichtung zum Dekodieren nach Anspruch 15, dadurch gekennzeichnet, daß die genannten dritten Mittel umfassen:

— einen ersten Umschalter (296), um eine Blockierspannung an die Eingänge zum Blockieren (s) der Zellen (T1) des Zählers zum Steuern während der Dauer des ersten Steuersignals (Y) anzulegen und um diese Eingänge mit dem Umschalter (291) für die Mittel zur Steuerung der binären Recheneinheit während der übrigen Zeit zu verbinden;

— einen zweiten Umschalter (297), um während der Dauer des ersten Steuersignals (Y) die Koeffizienten ($d_N$), die dem NAND-Gate (295) sowie den ersten Eingängen zur Steuerung (g) der Zellen (T2') oder den zweiten Koeffizienten-Eingängen (k) der Zellen (T3) zugeführt werden, durch die durch die genannten ersten Mittel wiedergegebenen Koeffizienten zu ersetzen; und

— einen dritten Umschalter (298) sowie einen vierten Umschalter (299), um während der Dauer des ersten Steuersignals (Y) an die Eingänge zur Steuerung (h', h'') der Zellen (T2', T3) ein Signal mit dem logischen Pegel *1* bzw. ein Signal mit dem logischen Pegel des zweiten Steuersignals (Z) anzulegen und während der übrigen Zeit das Ausgangssignal des NAND-Gates (295) und sein Komplement, das von einem Inverter (300; 410) abgegeben wird, wobei das erste Register auf den Wert X und das zweite Register auf den Wert *1* am Anfang jedes Verarbeitungszyklus eines Codeworts initialisiert wird.

**Claims**

1. A method of transmission, allowing the possibility of correction of packages of errors, of information messages with $k$ binary elements with the aid of code words with $n$ binary elements constituted by $s$ blocks of a magnitude $d_i$, wherein $i$ varies from 1 to $s$, $s$ being the number of polynomials $P_i(X)$ obtained on factorizing $X^n+1$ for the body GF(2) with two elements and $D_i$ being the degree of the polynomials $P_i(X)$, the said method being characterized in that for transmission,

— there is calculated for each block constituted by the coefficients of a polynomial $m_i(X)$, the product of the polynomials $\overline{M(X)}$, reciprocal of the polynomial M (X) of the degree $\leq$ k-1 associated with the message to be transmitted, with polynomial $A_i(X)$, being the reciprocal of the polynomial $P'_i(X)$, which is the derivative of the polynomial $P_i(X)$;

— the said product is divided by the polynomial $\overline{P_i(X)}$ and as the coefficients of the polynomial $m_i(X)$ use is made of the coefficients of the remainder from such division, in accordance with the relationship $m_i(X) \equiv \overline{M(X)} \, A_i(X) \, [P_i(X)]$, said coefficients constituting the binary elements of the corresponding transmitted block; and for reception:

— there is calculated for each received block a polynomial $S_i(X)$ with $n$ coefficients which is the product of the polynomial $\overline{m'_i(X)} = X^{d_i-1}m'_i(X^{-1})$, the reciprocal of the polynomial $m'_i(X)$ associated with the received block, with a reconstitution polynomial $R_i(X) = (X^n+1)/(P_i(X))$, the sum of the said polynomials $S_i(X)$ representing the superposition of the transmitted message $X^{n-k}.M(X)$, and an error syndrome;

— with the aid of the n-k first coefficients of the sum of the polynomials $S_i(X)$ there are determined the coefficients of a polynomial $\sigma(X)$, the product of the polynomials $P_i(X)$ corresponding to $i$ erroneous blocks;

— there are calculated the $k$ maximum significance coefficients of a correction polynomial K(X) such that:

$$K(X) \equiv \sum_{j=1}^{s} S_j(X) \quad [X^{n-k}] \quad \text{and} \quad \sum_{m=0}^{t_x} \sigma_m \cdot k_{p-m} = 0 \quad \text{for } n-1 \geq p \geq n-k$$

26

wherein $\sigma_m$ represents the coefficients of the polynomial $\sigma(X)$ of the maximum degree $t_x$ authorized for a valid correction and $k_{p-m}$ represents the coefficients of the polynomial $K(X)$; and

— the sum is taken of each of the highest of the said $k$ maximum significance coefficients of the polynomial $K(X)$ and of those coefficients having the same significance of the sum of the polynomials $S_i(X)$ in order to obtain the $k$ corrected binary elements of the received message.

2. The method as claimed in claim 1, characterized in that the determination of the polynomial $\sigma(X)$ is performed using a modification of the Berlekamp-Massey algebraic decoding algorithm.

3. An apparatus for encoding for the transmission of information messages in accordance with the method as claimed in claim 1 or claim 2, characterized in that it comprises $s$ circuits (CR1 to CR6) for the respective calculation of $s$ blocks to be transmitted, each of these circuits being constituted by a linear counter-reaction circuit (101, 130; 102, 103, 131; . . . ; 116 to 121 and 139 through 141) which receives at its input or inputs the said $k$ binary elements of the message in an increasing order, the input or inputs being disposed in such a manner as to ensure a premultiplication by the polynomial $A_i(X)$, and whose counter-reaction connections are disposed in such a manner as to perform division by the polynomial $\overline{P_i(X)}$.

4. The encoding apparatus as claimed in claim 3, characterized in that it is provided with means (101' through 121') in order to extract from the said registers (101 through 121) the $n$ binary elements of the code word to be transmitted which are present in such register as from the supply of the last binary element of the message.

5. The decoding apparatus allowing the correction of errors for the reception of transmitted information messages in accordance with the transmission method as claimed in claim 1 or in claim 2, characterized in that it comprises:

— $s$ calculation circuits (CR' through CR6') and means (201' through 221') in order to transfer to them respectively the $s$ received blocks, having $m'_i(X)$ as associated polynomials, in order to calculate the coefficients of the said polynomials $S_i(X)$ in accordance with the relationship $S_i(X) = \overline{m'_i(X)}R_i(X)$ wherein $\overline{m'_i(X)}$ is the reciprocal polynomial of the polynomial $m'_i(X)$ and wherein $R_i(X) = (X^n+1)/P_i(X))$ is the re-constitution polynomial;

— adding means (240 through 243) in order to derive the sum of all the polynomials $S_i(X)$;

— a binary calculating unit (250 through 290, 294, 295) for implementing an algebraic Berlekamp-Massey decoding algorithm and comprising a first shift register ($\sigma'$ and 305) and second shift register ($\sigma$, 308) interconnected by logic circuits (301 through 304, 306, 307), a third shift register (271 through 276), binary multiplying (280 through 285) and summating (286 through 289) circuits for producing the products term by term of the contents of the second and third registers and then producing the sum of such products, a binary adder (290) performing the addition of the said sum to the corresponding coefficient of the polynomial which is the sum of the polynomials $S_i(X)$ and controlling circuits (250 through 254; 294, 295) comprising a counter (250 through 254) controlled to control the said logic circuits;

— control means (291 through 293) in order to cause the said binary calculation unit to function in accordance with the said algorithm during the time the said adding means (240 through 243) are supplying the n-k first coefficients to the adder (290) of the binary calculating unit and to the input of the third register (271 through 276) in such a manner that the coefficients of the polynomial $\sigma 4(x)$, the product of the polynomials $P_i(X)$ corresponding to the erroneous blocks $i$, are present in the second register at the end of the said time, and in order to then cause the said unit to act to calculate the coefficients with the maximum significance of the correction polynomial $K(X)$ in accordance with the relationship:

$$\sum_{m=0}^{t_x} \sigma_m \cdot k_{p-m} = 0 \quad \text{for } n-1 \geq p \geq n-k$$

wherein $k_{p-m}$ represents the coefficients of the polynomial $K(X)$ and $\sigma_m$ those of the polynomial $\sigma(X)$ with the maximum degree $t_x$, the said control means ensuring the maintenance of the coefficients $\sigma_m$ in the second register during the entire time of supply of the $k$ coefficients with the largest significance of the polynomial which is the sum of the polynomials $S_i(X)$ and ensuring the dispatch of the output sum of the summating binary circuits (286 through 289) of the binary calculating unit to the input of the said third register.

6. The decoding apparatus as claimed in claim 5, characterized in that the said logic circuits (301 through 304, 306 and 307) are constituted in such a manner as to form, with the corresponding stages (305, 308) of the first and second registers, identical cells (T2), comprising two data inputs (c, d), two data outputs (e, f) and two control inputs (g, h), and comprising, for each cell (T2), a switch (301 through 304) with two inputs connected respectively with the inputs (c, d) of the cell, an output connected with the input of the stage (305) of the first register and a control input connected with the second control input (h) of the cell, and an AND gate (306) connecting the output of the stage of the first register with the input of the corresponding stage (308) of the second register by the intermediary of an exclusive OR gate (307) whose other input is connected with the output of the said stage of the second register, the control input of the said gate (306) being connected with the first control input (g) of the cell (T2) and the outputs of the stages (305, 308) of the first and of the second register being connected respectively with the outputs (e, f) of the cell, and in that the outputs (e, f) of each cell are respectively connected with the data inputs (c, d) of the following cell, the data inputs (c, d) of the first cell (261) respectively receiving logic levels $0$ and $1$.

7. The decoding apparatus as claimed in claim 6, characterized in that the said controlled counter (250 through 254) of the control circuits of the binary calculating unit is constituted by $e$ stages (T1) in series, wherein $e$ is such that $2^e \geq 2(n-k)$, the last stage (254) supplying the binary two's complement sign element and each stage (T1) having an input for placement in series (p), an output for placement in series (q), a status output (t) of the stage, a disenabling input (s) and a control input (r) to cause either normal counting or inversion of the binary element contained in the stage, in that the said control circuits furthermore comprise a NOT-AND gate (295), whose one input is connected via an inverter (294) with the status output (t) of the last stage (254) of the counter, whose second input is connected with all the first control inputs (g) of the cells (T2) of the binary calculating unit and whose output is connected with the second control inputs (h) of the said cells and with the control inputs (r) of the stages (T1) of the counter, and in that the said control means comprise switches (291, 292, 293) in order, during the n-k first coefficients of the polynomials $S_i(X)$, to apply an enabling logic level to the disenabling input(s) of the stages of the counter, to connect the input of the third register (271 through 276) with the input receiving the coefficients of the sum of the polynomials $S_i(X)$ and to connect the output of the binary adder (290) of the binary calculation unit with the first control inputs (g) of all the cells (261 through 266) and with the second input of the NOT-AND gate (295), and, during the $k$ last coefficients of the polynomial $S_i(X)$, to apply a disenabling logic level to the disenabling input(s) of the stages of the counter, to connect the input of the third register with the sum output of the summating binary circuits (286 through 289) of the binary calculating unit and to connect the first control inputs (g) of the cells and the second input of the NOT-AND gate with a $O$ logic level.

8. The decoding apparatus allowing the correction of errors and the processing of erased blocks as claimed in any one of the preceding claims 5 through 7, characterized in that the said logic circuits of the binary calculation unit are constituted in such a manner as to form with the corresponding stages (305, 308) of the first and second registers, identical cells (T2'), comprising two data inputs (c, d) two data outputs (e, f) and three control inputs (g, h', h'') and comprise for each cell (T2'), a three-way switch (315 through 317) having two inputs connected with the two data inputs (c, d) of the cell, two control inputs connected with the second and third control inputs (h', h'') of the cell and one output connected with the input of the stage (305) of the first register and supplying either one or other of the coefficients present at the data inputs (c, d) of the cell, or supplying their binary sum in accordance with the logical levels applied to the control inputs.

9. The decoding apparatus allowing the correction of errors for the reception of information messages transmitted in accordance with the transmission method as claimed in claim 1, characterized in that it comprises:

— $s$ calculation circuits (CR1' through CR6') and means (201' through 221') in order to transfer to them the $s$ received blocks, having $m_i'(X)$ as associated polynomials, in order to calculate the coefficients of the said polynomials $S_i(X)$ in accordance with the relationship $S_i(X) = \overline{m_i'(X)R_i}(X)$ wherein $\overline{m_i'(X)}$ is the reciprocal polynomial of the polynomial $m_i'(X)$ and wherein $R_i(X) = (X^n+1)/P_i(X)$ is the reconstitution polynomial;

— adding means (240 through 243) in order to form the sum of all the polynomials $S_i(X)$;

— a binary calculating unit (250 through 254, 294, 295, 400.0 through 400.11, 401, 402, 406, 408 through 410) for implementing a decoding algorithm derived from the Berlekamp-Massey algorithm and comprising a first shift register ($\sigma'$ and 420) and second shift register ($\sigma$, 421) interconnected by first logic circuits (424 through 426, 430, 431) a third shift register (q', 422) and a fourth shift register (q, 423) interconnected with each other and with the first a second registers by second logic circuits (427 through 429, 432 through 437), a binary adder (406) performing the addition of the coefficient ($d_N$) present at the output of the last stage of the fourth register to the corresponding coefficient of the polynomial which is the sum of the polynomials ($S_i(X)$, AND gates (408, 409) in order to apply, at the inputs of the first stage of the third and fourth registers, respectively, the product of the outputs of the last stage of the first and second registers on the one hand with the successive coefficients of the polynomial which is the sum of the polynomials $S_i(X)$ during the time of supply of the n-k first coefficients and on the other hand with said coefficient ($d_N$) as an output of the fourth register, during the supply of the $k$ last coefficients, and comprising control circuits (250 through 254; 294, 295, 410) comprising a counter (250 through 254) operated to control the said logic circuits;

— control means (291, 403 through 405) in order to cause the said binary calculation unit to function in accordance with the said algorithm during the time of supply of the n-k first coefficients by the fourth register in such a manner that the coefficients of the polynomial $\sigma(X)$, the product of the polynomials $P_i(X)$ corresponding to the erroneous blocks $i$, are present in the second register at the end of the said time, and in order to then cause the said unit to act to calculate the coefficients with the largest significance of the correction polynomial $K(X)$ in accordance with the relationship:

$$\sum_{m=0}^{t_x} \sigma_m \cdot k_{p-m} = 0 \quad \text{for } n-1 \geq p \geq n-k$$

wherein $k_{p-m}$ represents the coefficients of the polynomial $K(X)$ and $\sigma_m$ those of the polynomial $\sigma(X)$ with the maximum degree $t_x$, the successive coefficients $k_i$ being supplied to the output of the fourth register and said control means ensuring the maintenance of the coefficients $\sigma_m$ in the second register during the entire time of supply of the $k$ coefficients with the largest significance of the polynomial which is the sum of the polynomials $S_i(X)$.

10. The decoding apparatus as claimed in claim 9, characterized in that the binary calculating unit is designed in such a manner that at the instant of the index $N+1$ ($N < (n-k)$, the coefficients which are registered in the $i$ index stages of the first to fourth registers are given by the following relationships

A) If $d_N = 0$

$$\sigma_i'^{(N+1)} \longleftarrow \sigma_{i-1}'^{(N)} \quad \text{and} \quad \sigma_i^{(N+1)} \longleftarrow \sigma_i^{(N)}$$

$$q_i'^{(N+1)} \longleftarrow q_i'^{(N)} \oplus s_N \, \sigma_i'^{(N)}$$

$$q_i^{(N+1)} \longleftarrow q_{i+1}^{(N)} \oplus s_N \, \sigma_{i+1}^{(N)}$$

B) If $d_N = 1$ et $F < 0$

$$\sigma_i'^{(N+1)} \longleftarrow \sigma_{i-1}'^{(N)} \quad \text{and} \quad \sigma_i^{(N+1)} \longleftarrow \sigma_i^{(N)} \oplus \sigma_i'^{(N)}$$

$$q_i'^{(N+1)} \longleftarrow q_i'^{(N)} \oplus s_N \, \sigma_i'^{(N)}$$

$$q_i^{(N+1)} \longleftarrow q_{i+1}^{(N)} \oplus s_N \, \sigma_{i+1}^{(N)} \oplus q_{i+1}'^{(N)} \oplus s_N \, \sigma_{i+1}'^{(N)}$$

C) If $d_N = 1$ et $F \geq 0$

$$\sigma_i'^{(N+1)} \longleftarrow \sigma_{i-1}^{(N)} \quad \text{and} \quad \sigma_i^{(N+1)} \longleftarrow \sigma_i^{(N)} \oplus \sigma_i'^{(N)}$$

$$q_i'^{(N+1)} \longleftarrow q_i^{(N)} \oplus s_N \, \sigma_i^{(N)}$$

$$q_i^{(N+1)} \longleftarrow q_{i+1}^{(N)} \oplus s_N \, \sigma_{i+1}^{(N)} \oplus q_{i+1}'^{(N)} \oplus s_N \, \sigma_{i+1}'^{(N)}$$

wherein $D_N$ is the coefficient supplied at the output of the fourth register, F is the number registered in the counter (250 through 254) of the control circuits, and $i$ varies from 1 to n-k for the determination of $\sigma$ and $\sigma'$ and from 0 to n-k-1 for the determination of q and q'.

11. The decoding apparatus as claimed in claim 9 or claim 10, characterized in that the said first and second logic circuits (424 through 426, 430, 431; 427 through 429, 432 through 437) are constituted in such a manner as to form, with the stages of the order i+1 of the first and second registers and the stages of the order $i$ of the third and fourth registers, wherein $i$ varies from 0 to n-k-1, identical cells (T3, 400.0 through 400.11), comprising a first group of two data inputs (c', d') and two data outputs (e', f') for the first and the second registers, a second group of two data inputs (m', n') and two data outputs (p', q') for the third and fourth registers, two control inputs (h', h'') and two coefficient inputs (j, k) connected to common distribution buses (401, 402) and comprising, for each cell (T3):

— a first three-way switch (424 through 426) comprising two inputs connected with first data inputs (c', d') of the cell, two control inputs connected with control inputs (h', h'') of the cell and an output connected with the input of the stage (420) of the first register and either supplying one or the other of the coefficients present at the first inputs (c', d') of the cell, or supplying their binary sum in accordance with the logic levels applied to the control inputs;

— a first AND gate (430) connecting the output of the stage of the first register with the input of the corresponding stage (421) of the second register by the intermediary of an exclusive OR gate (431), whose other input is connected with the output of the same stage of the second register, the other input of the AND gate (430) being connected with the second coefficient input (k) of the cell and the outputs of the stages (420, 421) of the first and of the second register being connected, respectively, with the first data outputs (e', f') of the cell;

— a second three-way switch (427 through 429) comprising two inputs connected with the second data outputs (p', q') of the cell, two control inputs connected with the control inputs (h', h'') of the cell and an output connected with the input of the stage (422) of the third register and either supplying one or the other of the coefficients present at the second outputs (p', q') of the cell or supplying their binary sum in accordance with the logic levels applied to the control inputs;

— a second AND gate (423) connected with the data input (c') associated with the first register, and with the first coefficient input (j) of the cell, and whose output is connected with one input of an exclusive OR gate (433) having its one input connected with the output of the stage of the third register (422) and its output connected with the data output (p') of the second group, associated with the third register;

— a third AND gate (436) connecting the data input (m') of the second group, associated with the third register, with the input of the corresponding stage (423) of the fourth register by the intermediary of an exclusive OR gate (437) whose other input is connected with the data input (n') of the second group, associated with the fourth register, the other input of the AND gate (436) being connected with the second coefficient input (k) of the cell; and

— a fourth AND gate (434) connecting the data input (d') of the first group, associated with the second register, with the data output (q') of the second group, associated with the fourth register, by the intermediary of an exclusive OR gate (435), whose other input is connected with the output of the corresponding stage (423) of the fourth register, the other input of the fourth AND gate (434) being connected with the first coefficient input (j) of the cell;

and in that the data inputs (c', d') of the first group and the data outputs (p', q') of the second group of any cell (400.i) are connected, respectively, with the data outputs (e', f') of the first group and with the data inputs (m', n') of the second group of the preceding cell [400.(i-1)], the data outputs (e', f') of the first group and the data inputs (m', n') of the second group of the last cell (400.11) being interconnected by AND gates (408, 409) of the binary calculation unit, the data output (q') of the second group of the first cell (400.0) being connected with the binary adder (406) of the binary calculation unit and the data input (c') of the first group of this cells receiving a $0$ logic level.

12. The decoding apparatus as claimed in claim 11, characterized in that the said controlled counter (250 through 254) of the control circuits of the binary calculation unit is constituted by $e$ stages (T1) in series, wherein $e$ is such that $2^e \geq 2(n-k)$, the last stage (254) supplying a binary two's complement sign element and each stage (T1) having a putting in series input (p), a putting in series output (q), a status output (t) of the stage, a disenabling input (s) and a control input (r) in order to implement either normal counting or the inversion of the binary element contained in the stage, in that the said control circuits furthermore comprise a NOT-AND gate (295), whose one input is connected by an inverter (294) with the status output (t) of the last stage (254) of the counter, whose second input is connected with the second common distribution bus 402 connected with all the second coefficient inputs (k) of the cells (T3) of the binary calculating unit and whose output is connected directly with all the control inputs (r) of the stages (T1) of the counter and with all the first control inputs (h') of the cells (T3) and, by the intermediary of an inverter (410), with all the second control inputs (h'') of the said cells, and in that the said control means comprise switches (291, 403 through 405) in order, during the supply of the n-k first coefficients of the polynomial $S_i(X)$, to apply an enabling logic level to the disenabling inputs (s) of the stages of the counter, to connect the first common distribution bus (401) with the output (SR) supplying the coefficients of the polynomial which are the sum of the polynomials $S_i(X)$ to connect the second common distribution bus (402) with the data output (q'), associated with the fourth register, of the first cell (400.0) and to apply an $1$ logic level to the data input (d') of this cell, associated with the second register, and in order, during the $k$ last coefficients of the polynomial $S_i(X)$, to apply a disenabling logic level to the disenabling inputs (s) of the stages of the counter, to connect the first distribution bus (401) to the data output (q'), associated with the fourth register, of the first cell (400.0), to apply a $0$ logic level to the second distribution bus (402) and to apply $0$ logic level to the data input (d') of this cell, associated with the second register.

13. The decoding apparatus as claimed in any one of the preceding claims 5 through 7 and 9 through 12, characterized in that the said $s$ calculation circuits (CR1' through CR6') each comprise a linear counter-reaction register (201; 202, 203, 230; . . . ; 216 through 221, 236 through 238), whose counter-reaction terminals are so placed as to perform division by the polynomial $\overline{P_i(X)}$, same being the reciprocal of the polynomial $P_i(X)$.

14. The decoding apparatus as claimed in any one of the preceding claims 5 through 7 and 9 through 13, characterized in that each stage (T1) of the counter comprises a NOT-AND gate (310) whose inputs are connected respectively with the data input (p) and with the control input (r) of the stage, an AND gate (311) whose inputs are connected, respectively, with the output of the NOT-AND gate (310) and with the disenabling input (s) of the stage, an exclusive OR gate (312) connected with the output of the AND gate, a register stage (313) whose input is connected with the output of the exclusive OR gate (312) and whose output is connected with the status output (t) of the stage (T1) and with the other input of the exclusive OR gate (312), and a NOT-AND gate (314), whose inputs are connected, respectively, with the outputs of the register stage (313) and of the AND gate (311) and whose output constitutes the output (q) of the stage, the data input (p) of the first stage of the counter receiving a *0* logic level.

15. The decoding apparatus allowing the correction of errors and the processing of erased blocks as claimed in any one of the preceding claims 8 through 14, characterized in that it comprises:

— first means (R1, R2) to store the coefficients in a memory and to restitute them during later processing, such coefficients relating to terms with a degree equal to or greater than unity, of the all the polynomial $P_i(X)$ associated with the erased blocks, in the order in which same are received;

— second means (Cmp, Decmp, Dec, Pe, Sq) in order to supply a first control signal (Y) with a duration equal to the time necessary for the first means to restitute all the erased polynomial coefficients corresponding to the code word being processed and a second control signal (Z) passing to the *1* logic level during the supply by the said second means of the last coefficient, associated with the term with the highest degree, of each polynomial $P_i(X)$ corresponding to an erased block;

— and third control means (296 through 299) in order, during the duration of the first control signal (Y) and as from the supply of the first coefficient ($s_0$) to the input of the binary calculating unit, to control the operation of the binary calculation unit, on the basis of the said control signals (Y, Z), in such a manner that at the end of the first control signal (Y) the second register ($\sigma$, 308; $\sigma$, 421) has available coefficients of the polynomial $\sigma_{eff}(X)$ equal to the product of the polynomials $P_i(X)$ corresponding to the erased blocks, said polynomial $\sigma_{eff}(X)$ serving as an initial content of the second register then for the successive function in accordance with the decoding algorithm.

16. The decoding apparatus as claimed in claim 15, characterized in that the said third means comprise:

— a first switch (296) in order to apply a disenabling voltage to the disenabling inputs (s) of the cells (T1) of the control counter during the duration of the first control signal (Y) and in order to connect these inputs with the switch (291) of the control means of the binary calculation unit during the rest of the time;

— a second switch (297) in order to replace, during the duration of the first control signal (Y), the coefficients ($d_N$), supplied to the NOT-AND gate (295) and to the first control inputs (g) of the cells (T2') or to the second coefficient inputs (k) of the cells (T3), by the coefficients restituted by the said first means; and

— a third and a fourth switch (298, 299) in order to apply to the control inputs (h', h'') of the cells (T2'; T3), during the duration of the first control signal (Y), respectively, a signal having the *1* logic level and a signal having the logic level of the second control signal (Z) and, during the rest of the time, respectively, the output signal of the NOT-AND gate (295) and its complement furnished by an inverter (300; 410), the first register being initialized at the value X and the second register at the value *1* at the start of each cycle of processing a code word.

FIG. 1

Fig. 2

Fig. 3

Fig. 4

Fig . 5

Fig. 6

Fig. 7

Fig. 8